(19) Europäisches Patentamt
European Patent Office
Office européen des brevets

(11) **EP 4 531 531 A1**

(12) **EUROPEAN PATENT APPLICATION**

(43) Date of publication:
**02.04.2025 Bulletin 2025/14**

(21) Application number: **23200088.5**

(22) Date of filing: **27.09.2023**

(51) International Patent Classification (IPC):
***H10K 85/60*** *(2023.01)* ***H10K 50/18*** *(2023.01)*

(52) Cooperative Patent Classification (CPC):
**H10K 85/654;** H10K 50/18; H10K 85/615

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicant: **Novaled GmbH**
**01099 Dresden (DE)**

(72) Inventors:
- **SCHOLZ, Johannes**
  **01099 Dresden (DE)**
- **STENNETT, Thomas**
  **01099 Dresden (DE)**
- **MAI, Susanne**
  **01099 Dresden (DE)**
- **GALÀN GARCIA, Elena**
  **01099 Dresden (DE)**

(74) Representative: **Bittner, Thomas L.**
**Boehmert & Boehmert**
**Anwaltspartnerschaft mbB**
**Pettenkoferstrasse 22**
**80336 München (DE)**

(54) **ORGANIC LIGHT EMITTING DEVICE, DISPLAY DEVICE COMPRISING THE SAME AND COMPOUND**

(57) The present invention relates to an organic light emitting device, to a display device comprising the same and to a compound.

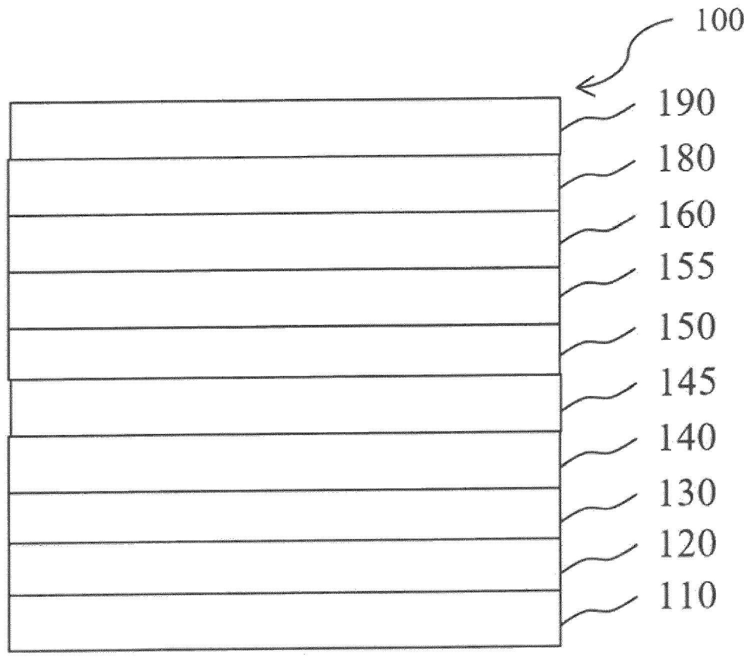


Fig. 1

EP 4 531 531 A1

## Description

The present invention relates to an organic light emitting device and to a display device comprising the organic light emitting device. The present invention further relates to a compound.

BACKGROUND OF THE INVENTION

Organic semiconducting devices, such as organic light-emitting diodes OLEDs, which are self-emitting devices, have a wide viewing angle, excellent contrast, quick response, high brightness, excellent operating voltage characteristics, and color reproduction. A typical OLED comprises an anode, a hole transport layer HTL, an emission layer EML, an electron transport layer ETL, and a cathode, which are sequentially stacked on a substrate. In this regard, the HTL, the EML, and the ETL are thin films formed from organic compounds.

When a voltage is applied to the anode and the cathode, holes injected from the anode move to the EML, via the HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has excellent efficiency and/or a long lifetime.

Performance of an organic light emitting diode may be affected by characteristics of the organic semiconductor layer, and among them, may be affected by characteristics of an organic material of the organic semiconductor layer.

Particularly, development of an organic semiconductor layer being capable of increasing electron mobility and simultaneously increasing electrochemical stability is needed so that the organic semiconducting device, such as an organic light emitting diode, may be applied to a large-size flat panel display.

It is, therefore, the object of the present invention to provide organic light emitting diodes and compounds for preparing the same overcoming drawbacks of the prior art, in particular providing compounds for use in organic light emitting diodes comprising the same helpful to improve the performance thereof, especially with respect to efficiency and/or operating voltage.

DISCLOSURE

This object is achieved by an organic light emitting device comprising an anode, a cathode, an emission layer, a hole blocking layer, and an electron transport layer,
wherein

- the emission layer, the hole blocking layer and the electron transport layer are arranged between the anode and the cathode;
- the hole blocking layer and the electron transport layer are arranged between the emission layer and the cathode;
- the hole blocking layer is arranged between the emission layer and the electron transport layer;
- the hole blocking layer is in direct contact with the electron transport layer;
- the hole blocking layer does not comprise an electrical dopant;
- the hole blocking layer comprises a compound of formula (I)

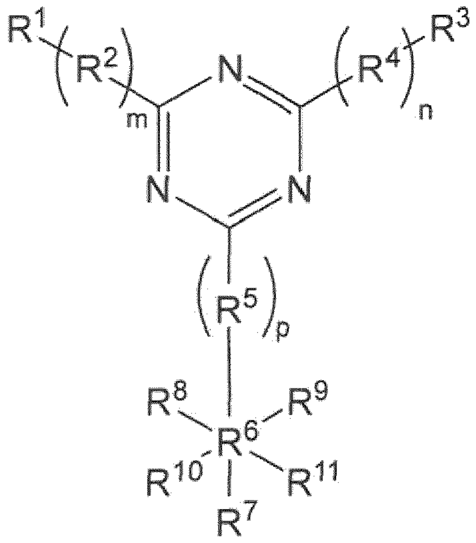

(I)

wherein in formula (I)

- m and n are independently 0 or 1;
- p is 0 or 1;
- $m + n + p \geq 1$;
- $R^1$ and $R^3$ are independently substituted or unsubstituted $C_6$ to $C_{18}$ aryl;
- $R^2$ and $R^4$ are independently substituted or unsubstituted $C_6$ to $C_{18}$ arylene;
- $R^5$ is substituted or unsubstituted $C_6$ to $C_{18}$ arylene;
- $R^6$ is selected from the group consisting of phenylene, pyrazinylene and anthracenylene;
- $R^7$ is unsubstituted $C_6$ to $C_{18}$ aryl;
- $R^8$ to $R^{11}$ are independently selected from the group consisting of H and unsubstituted $C_6$ to $C_{18}$ aryl;
- in case that one or more of $R^1$ to $R^5$ is substituted, the one or more substituents are independently $C_1$ to $C_6$ alkyl; and
- at least one of $R^1$ and $R^3$ is substituted with at least one $C_1$ to $C_6$ alkyl substituents; and/or at least one of $R^2$, $R^4$ and $R^5$ is substituted with at least one $C_1$ to $C_6$ alkyl substituents.

The object is further achieved by a device comprising the organic light emitting device according to the present invention, wherein the device is a display device or a lighting device.

The object is further achieved by a compound of formula (II)

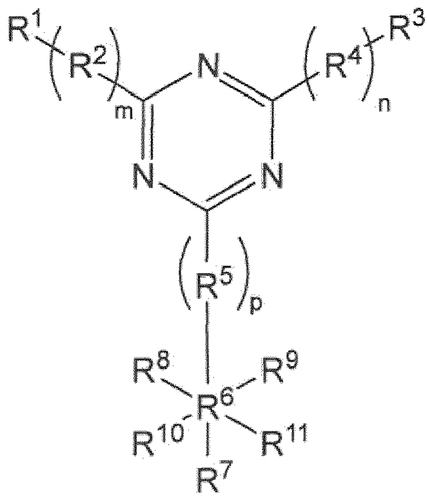

(II)

wherein in formula (II)

- m and n are independently 0 or 1;
- p is 0, 1 or 2;
- m + n + p ≥ 1;
- $R^1$ and $R^3$ are independently substituted or unsubstituted phenyl;
- $R^2$ and $R^4$ are independently substituted or unsubstituted phenylene;
- each $R^5$ is independently substituted or unsubstituted phenylene;
- $R^6$ is selected from the group consisting of phenylene, pyrazinylene and anthracenylene;
- $R^7$ is unsubstituted phenyl;
- $R^8$ to $R^{11}$ are independently selected from the group consisting of H and unsubstituted phenyl;
- in case that one or more of $R^1$ to $R^5$ is substituted, the one or more substituents are independently $C_1$ to $C_6$ alkyl; and
- at least one of $R^1$ and $R^3$ is substituted with at least one $C_1$ to $C_6$ alkyl substituents; and/or at least one of $R^2$, $R^4$ and $R^5$ is substituted with at least one $C_1$ to $C_6$ alkyl substituents.

Compound of formula (I)

The organic light emitting device comprises in an electrically undoped hole blocking layer thereof a compound of formula (I)

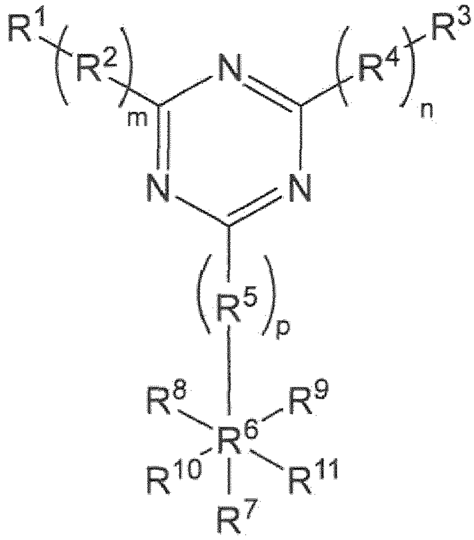

(I).

Especially, if not mentioned else explicitly, all compounds, especially the compound of formula (I), groups, moieties, substituents etc. shown herein, especially by structural formulas, by systematic names etc. encompass the respective partially and fully deuterated derivatives thereof, wherein it may be provided that substitution beyond deuteration is excluded. If a compound, group, moiety, substituent etc. is mentioned to be unsubstituted, this does not exclude substitution with D.

In accordance with the present disclosure, as an illustrative example using an arbitrary group A in a formula showing the following binding situation,

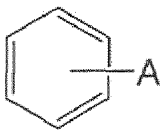

the group A may be bound to any suitable binding position.

m and n are independently 0 or 1.

p is 0 or 1.

$m + n + p \geq 1$. $(m + n + p)$ may be an integer from 1 to 3. $(m + n + p)$ may be 1 or 2.

$R^1$ and $R^3$ are independently substituted or unsubstituted $C_6$ to $C_{18}$ aryl. $R^1$ and $R^3$ may be independently substituted or unsubstituted $C_6$ to $C_{12}$ aryl. $R^1$ and $R^3$ may be independently substituted or unsubstituted $C_6$ to $C_{10}$ aryl. $R^1$ and $R^3$ may be independently substituted or unsubstituted phenyl.

In case that one or more of $R^1$ and $R^3$ is substituted, the one or more substituents are independently $C_1$ to $C_6$ alkyl. In case that one or more of $R^1$ and $R^3$ is substituted, the one or more substituents may be independently $C_1$ to $C_5$ alkyl. In case that one or more of $R^1$ and $R^3$ is substituted, the one or more substituents may be independently $C_1$ to $C_4$ alkyl. In case that one or more of $R^1$ and $R^3$ is substituted, the one or more substituents may be independently $C_1$ to $C_3$ alkyl. In case that one or more of $R^1$ and $R^3$ is substituted, the one or more substituents may be independently $C_1$ to $C_2$ alkyl. In case that one or more of $R^1$ and $R^3$ is substituted, the one or more substituents may be each methyl.

In case that one or more of $R^1$ and $R^3$ is substituted, the respective $R^1$ and/or $R^3$ (including all substituents) may be independently selected from the following groups Ia-1 to Ia-8

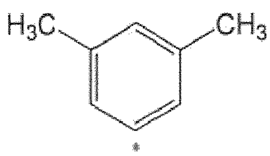 Ia-1 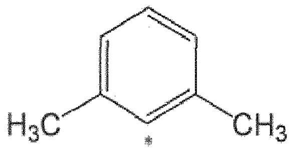 Ia-2 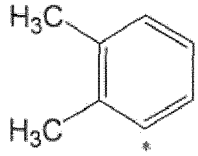 Ia-3

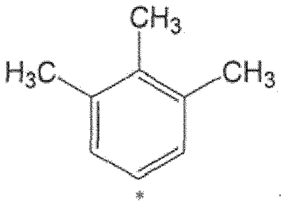 Ia-4 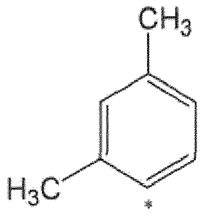 Ia-5 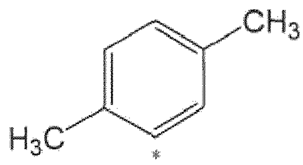 Ia-6

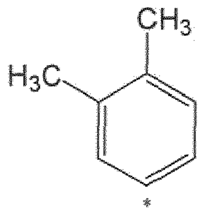 Ia-7 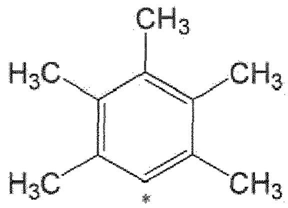 Ia-8

wherein "*" is the binding position, that is, the binding position to $R^2$ (for $R^1$) or $R^4$ (for $R^3$), in formula (I).

In case that one or more of $R^1$ and $R^3$ is substituted, the respective $R^1$ and/or $R^3$ including all substituents) may be independently selected from the following groups Ia-1 to Ia-3.

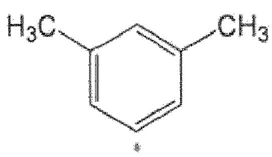 Ia-1 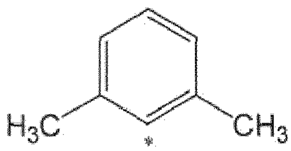 Ia-2 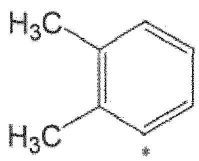 Ia-3

wherein "*" is the binding position, that is, the binding position to $R^2$ (for $R^1$) or $R^4$ (for $R^3$), in formula (I).

It may be provided that one or more of the $CH_3$ group(s) in 1a-1 to Ia-8 is/are replaced by $C_2$ to $C_6$ alkyl, $C_2$ to $C_4$ alkyl, $C_2$ to $C_3$ alkyl, or $C_2$ alkyl.

$R^2$ and $R^4$ are independently substituted or unsubstituted $C_6$ to $C_{18}$ arylene. $R^2$ and $R^4$ may be independently substituted or unsubstituted $C_6$ to $C_{12}$ arylene. $R^2$ and $R^4$ may be independently substituted or unsubstituted $C_6$ to $C_{10}$ arylene. $R^2$ and $R^4$ may be independently substituted or unsubstituted phenylene. $R^2$ and $R^4$ may be independently substituted or unsubstituted meta-phenylene.

$R^2$ and $R^4$ may be independently unsubstituted $C_6$ to $C_{18}$ arylene. $R^2$ and $R^4$ may be independently unsubstituted $C_6$ to $C_{12}$ arylene. $R^2$ and $R^4$ may be independently unsubstituted $C_6$ to $C_{10}$ arylene. $R^2$ and $R^4$ may be independently unsubstituted phenylene. $R^2$ and $R^4$ may be each unsubstituted meta-phenylene.

$R^5$ is substituted or unsubstituted $C_6$ to $C_{18}$ arylene. $R^5$ may be substituted or unsubstituted $C_6$ to $C_{12}$ arylene. $R^5$ may be substituted or unsubstituted phenylene, or substituted or unsubstituted biphenylene.

$R^5$ may be selected from the following groups Ib-1 to Ib-6

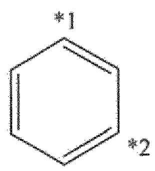 Ib-1 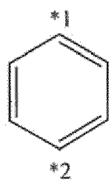 Ib-2 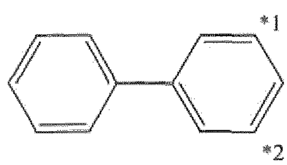 Ib-3

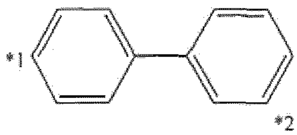 Ib-4 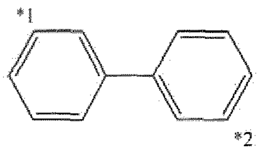 Ib-5 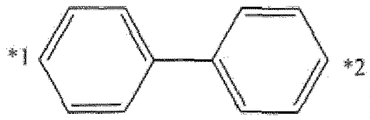 Ib-6

wherein "*1" is the binding position to

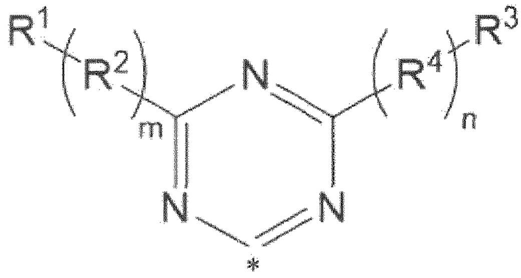

and "*2" is the binding position to $R^6$ in formula (I), wherein the respective Ib-1 to Ib-6 can be substituted or unsubstituted.

In case that one or more of $R^2$, $R^4$ and $R^5$ is substituted, the one or more substituents are independently $C_1$ to $C_6$ alkyl. In case that one or more of $R^2$, $R^4$ and $R^5$ is substituted, the one or more substituents may be independently $C_1$ to $C_5$ alkyl. In case that one or more of $R^2$, $R^4$ and $R_5$ is substituted, the one or more substituents may be independently $C_1$ to $C_4$ alkyl. In case that one or more of $R^2$, $R^4$ and $R^5$ is substituted, the one or more substituents may be independently $C_1$ to $C_3$ alkyl. In case that one or more of $R^2$, $R^4$ and $R^5$ is substituted, the one or more substituents may be independently $C_1$ to $C_2$ alkyl. In case that one or more of $R^2$, $R^4$ and $R^5$ is substituted, the one or more substituents may be methyl.

In case that one or more of $R^2$, $R^4$ and $R^5$ is substituted, the respective $R^2$, $R^4$ and $R^5$ (including all substituents) may be independently selected from or comprise one of the following groups Ic-1 to Ic-9

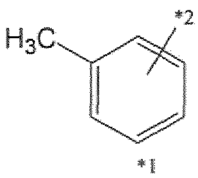 Ic-1 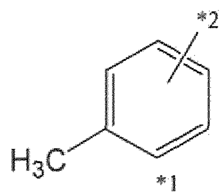 Ic-2 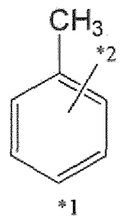 Ic-3 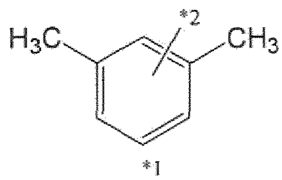 Ic-4

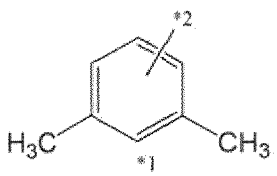 Ic-5 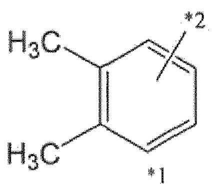 Ic-6 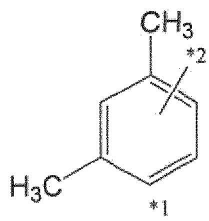 Ic-7

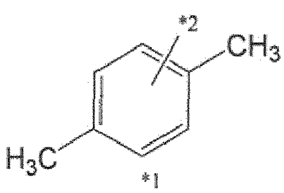 Ic-8 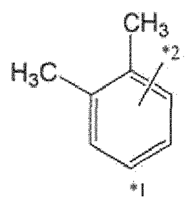 Ic-9

wherein "*1" and "*2" are the binding positions to the remaining part of formula (I).

Including all substituents (if any), $R^5$ may be selected from one of the following groups Id-1 to Id-6

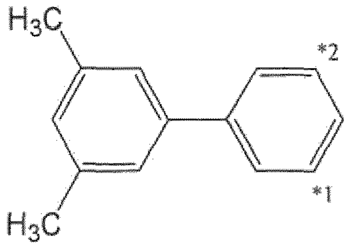 Id-1 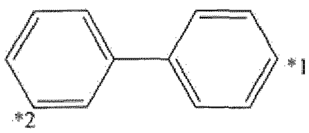 Id-2 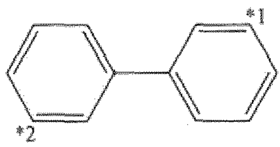 Id-3

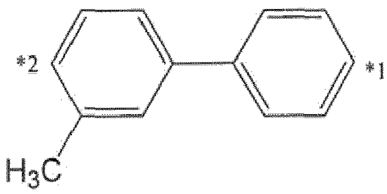 Id-4 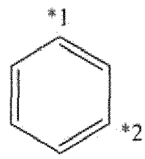 Id-5 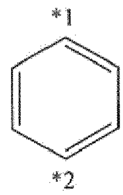 Id-6

wherein "*1" is the binding position to

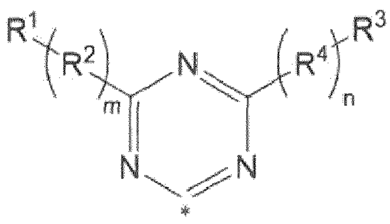

and "*2" is the binding position to $R^6$ in formula (I).

$R^6$ is selected from the group consisting of phenylene, pyrazinylene and anthracenylene. $R^6$ may selected from the group consisting of phenylene and pyrazinylene.

$R^6$ may be selected from one of the following groups Ie-1 to Ie-7

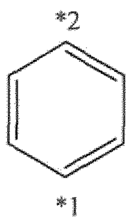 Ie-1 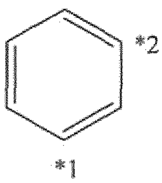 Ie-2 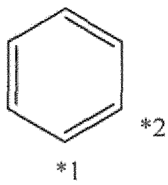 Ie-3 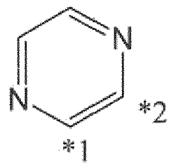 Ie-4 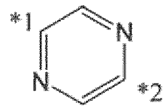 Ie-5

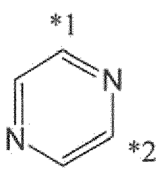 Ie-6 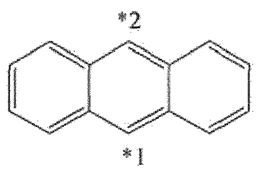 Ie-7

wherein "*1" is the binding position to $R^5$ and "*2" is the binding position to $R^7$ in formula (I).

$R^6$ may be selected from one of the following groups Ie-1 to Ie-6

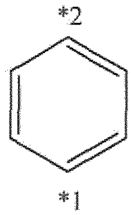 Ie-1 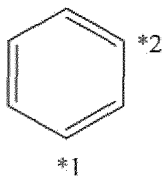 Ie-2 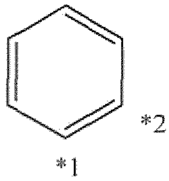 Ie-3 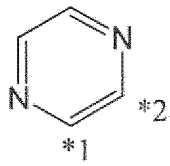 Ie-4 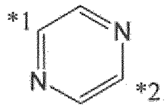 Ie-5

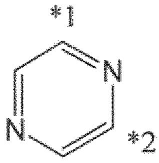 Ie-6

wherein "*1" is the binding position to $R^5$ and "*2" is the binding position to $R^7$ in formula (I).

In Ie-1 to Ie-7, $R^8$ to $R^{11}$ can be bonded to any carbon atom except for the carbon atoms labeled with "*1*" and "*2". If there are less than four carbon atoms to which $R^8$ to $R^{11}$ can be bonded one or more of $R^8$ to $R^{11}$ can be absent. For example, if there are only two carbon atoms to which $R^8$ to $R^{11}$ can be bonded, such as in Ie-4, $R^{10}$ and $R^{11}$ are absent and the respective group has the following formula Ie-4.1

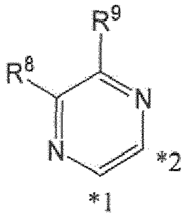 Ie-4.1.

$R^7$ is unsubstituted $C_6$ to $C_{18}$ aryl. $R^7$ may be unsubstituted $C_6$ to $C_{12}$ aryl. $R^7$ may be unsubstituted $C_6$ to $C_{10}$ aryl. $R^7$ may be unsubstituted phenyl.

$R^8$ to $R^{11}$ are independently selected from the group consisting of H and unsubstituted $C_6$ to $C_{18}$ aryl. $R^8$ to $R^{11}$ may be independently selected from the group consisting of H and unsubstituted $C_6$ to $C_{12}$ aryl. $R^8$ to $R^{11}$ may be independently selected from the group consisting of H and unsubstituted $C_6$ to $C_{10}$ aryl. $R^8$ to $R^{11}$ may be independently selected from the group consisting of H and unsubstituted phenyl.

If $R^6$ is phenylene, it can be provided that 1, 2 or 3 of $R^8$ to $R^{11}$ are H and the remaining $R^8$ to $R^{11}$ are unsubstituted $C_6$ to $C_{18}$ aryl. If $R^6$ is phenylene, it can be provided that 1, 2 or 3 of $R^8$ to $R^{11}$ are H and the remaining $R^8$ to $R^{11}$ are unsubstituted $C_6$ to $C_{12}$ aryl. If $R^6$ is phenylene, it can be provided that 1, 2 or 3 of $R^8$ to $R^{11}$ are H and the remaining $R^8$ to $R^{11}$ are unsubstituted $C_6$ to $C_{10}$ aryl. If $R^6$ is phenylene, it can be provided that 1, 2 or 3 of $R^8$ to $R^{11}$ are H and the remaining $R^8$ to $R^{11}$ are unsubstituted phenyl.

If $R^6$ is phenylene, it can be provided that at least one of $R^8$ to $R^{11}$ is unsubstituted $C_6$ to $C_{18}$ aryl and this unsubstituted $C_6$ to $C_{18}$ aryl is in ortho-position to the binding position of the phenylene ($R^6$) to $R^5$. If $R^6$ is phenylene, it can be provided that at least one of $R^8$ to $R^{11}$ is unsubstituted $C_6$ to $C_{12}$ aryl and this unsubstituted $C_6$ to $C_{12}$ aryl is in ortho-position to the binding position of the phenylene ($R^6$) to $R^5$. If $R^6$ is phenylene, it can be provided that at least one of $R^8$ to $R^{11}$ is unsubstituted $C_6$ to $C_{10}$ aryl and this unsubstituted $C_6$ to $C_{10}$ aryl is in ortho-position to the binding position of the phenylene ($R^6$) to $R^5$. If $R^6$ is phenylene, it can be provided that at least one of $R^8$ to $R^{11}$ is unsubstituted phenyl and this unsubstituted phenyl is in ortho-position to the binding position of the phenylene ($R^6$) to $R^5$.

If $R^6$ is phenylene, it can be provided that at least two of $R^8$ to $R^{11}$ are unsubstituted $C_6$ to $C_{18}$ aryl and these unsubstituted $C_6$ to $C_{18}$ aryls are in ortho-position with respect to each other. If $R^6$ is phenylene, it can be provided that at least two of $R^8$ to $R^{11}$ are unsubstituted $C_6$ to $C_{12}$ aryl and these unsubstituted $C_6$ to $C_{12}$ aryls are in ortho-position with respect to each other. If $R^6$ is phenylene, it can be provided that at least two of $R^8$ to $R^{11}$ are unsubstituted $C_6$ to $C_{10}$ aryl and these unsubstituted $C_6$ to $C_{10}$ aryls are in ortho-position with respect to each other. If $R^6$ is phenylene, it can be provided that at least two of $R^8$ to $R^{11}$ are unsubstituted phenyl and these unsubstituted phenyls are in ortho-position with respect to each other.

The feature of at least one of $R^8$ to $R^{11}$ being aryl and being in ortho position to the binding position of the phenylene ($R^6$) to $R^5$ and the feature of at least two of $R^8$ to $R^{11}$ being aryl and these aryls being in ortho-position with respect to each other as described in the two foregoing paragraphs may apply alternatively or together (and/or).

If $R^6$ is phenylene, the moiety

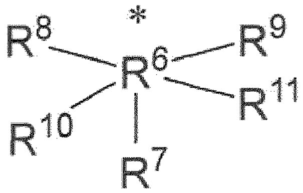

with "*" being the binding position to $R^5$ may be one of the following groups If-1 to If-3

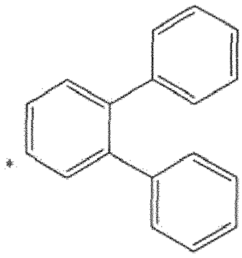

If-1

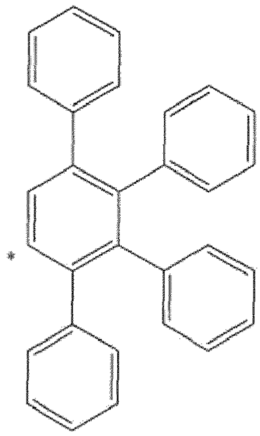

If-2

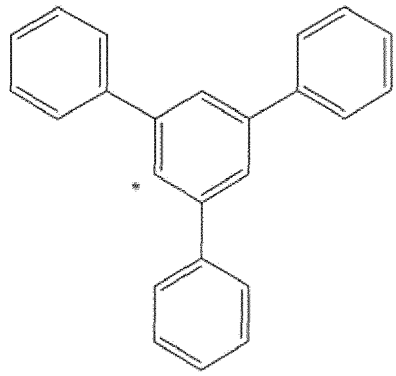

If-3.

If $R^6$ is pyrazinylene, the moiety

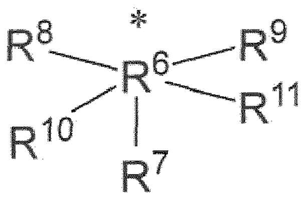

with "*" being the binding position to $R^5$ may be Ig-1

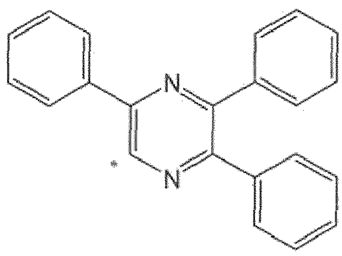

Ig-1.

If $R^6$ is anthracenylene, the moiety

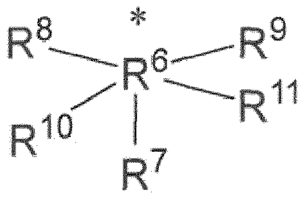

with "*" being the binding position to $R^5$ may be Ih-1

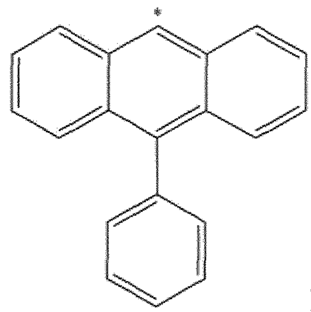

Ih-1.

At least one of $R^1$ and $R^3$ is substituted with at least one $C_1$ to $C_6$ alkyl substituent; and/or at least one of $R^2$, $R^4$ and $R^5$ is substituted with at least one $C_1$ to $C_6$ alkyl substituent. In one embodiment, at least one of $R^1$ and $R^3$ is substituted with at least one $C_1$ to $C_6$ alkyl substituent; and/or $R^5$ is substituted with at least one $C_1$ to $C_6$ alkyl substituent. In one embodiment, at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituent. In one embodiment, at least one of $R^1$ and $R^3$ is substituted with at least two $C_1$ to $C_6$ alkyl substituents; and/or $R^5$ is substituted with at least one $C_1$ to $C_6$ alkyl substituent. In one embodiment, at least one of $R^1$ and $R^3$ is substituted with one or two $C_1$ to $C_6$ alkyl substituent(s); and/or $R^5$ is substituted with one or two $C_1$ to $C_6$ alkyl substituent(s). In this regard, the $C_1$ to $C_6$ alkyl substituent can be independently selected as described above.

In one embodiment, the hole blocking layer comprises a compound of formula (I)

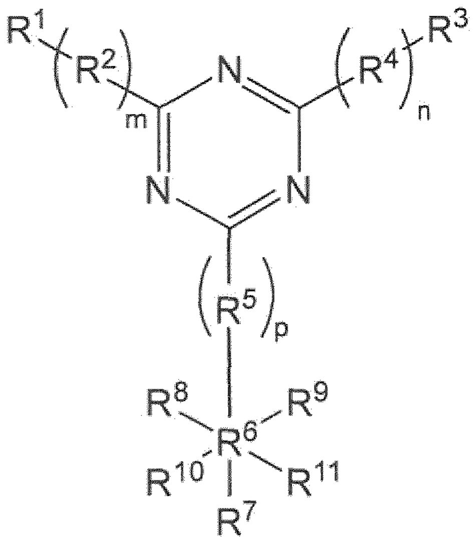

(I)

wherein in formula (I)

- m and n are independently 0 or 1;
- p is 0 or 1;
- $m + n + p \geq 1$;
- $R^1$ and $R^3$ are independently substituted or unsubstituted $C_6$ to $C_{18}$ aryl;
- $R^2$ and $R^4$ are independently substituted or unsubstituted $C_6$ to $C_{18}$ arylene;
- $R^5$ is substituted or unsubstituted $C_6$ to $C_{18}$ arylene;
- $R^6$ is selected from the group consisting of phenylene, pyrazinylene and anthracenylene;
- $R^7$ is unsubstituted $C_6$ to $C_{18}$ aryl;

- $R^8$ to $R^{11}$ are independently selected from the group consisting of H and unsubstituted $C_6$ to $C_{18}$ aryl;
- in case that one or more of $R^1$ to $R^5$ is substituted, the one or more substituents are independently $C_1$ to $C_6$ alkyl; and
- at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.
In one embodiment, the hole blocking layer comprises a compound of formula (I)

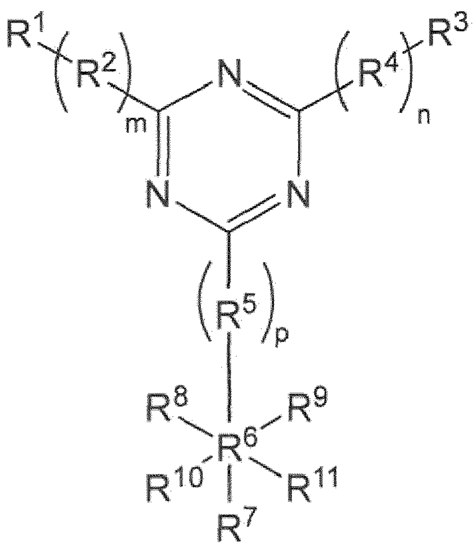

(I)

wherein in formula (I)

- m and n are independently 0 or 1;
- p is 0 or 1;
- $m + n + p \geq 1$;
- $R^1$ and $R^3$ are independently substituted or unsubstituted $C_6$ to $C_{18}$ aryl;
- $R^2$ and $R^4$ are independently substituted or unsubstituted $C_6$ to $C_{18}$ arylene;
- $R^5$ is substituted or unsubstituted $C_6$ to $C_{18}$ arylene;
- $R^6$ is selected from the group consisting of phenylene and pyrazinylene;
- $R^7$ is unsubstituted $C_6$ to $C_{18}$ aryl;
- $R^8$ to $R^{11}$ are independently selected from the group consisting of H and unsubstituted $C_6$, to $C_{18}$ aryl;
- in case that one or more of $R^1$ to $R^5$ is substituted, the one or more substituents are independently $C_1$ to $C_6$ alkyl; and
- at least one of $R^1$ and $R^3$ is substituted with at least one $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.
In one embodiment, the hole blocking layer comprises a compound of formula (I)

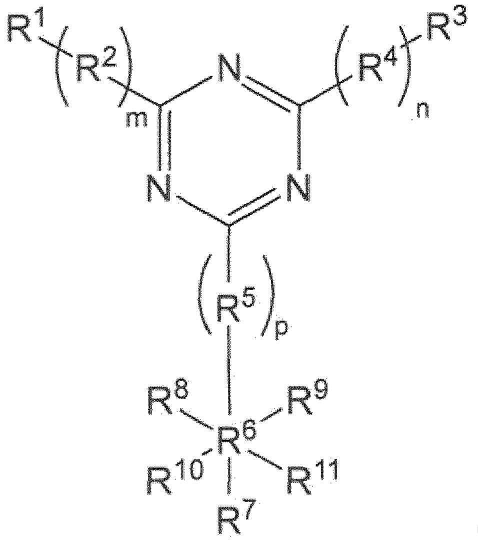

(I)

wherein in formula (I)

- m and n are independently 0 or 1;
- p is 0 or 1;
- m + n + p ≥ 1;
- $R^1$ and $R^3$ are independently substituted or unsubstituted $C_6$ to $C_{18}$ aryl;
- $R^2$ and $R^4$ are independently substituted or unsubstituted $C_6$ to $C_{18}$ arylene;
- $R^5$ is substituted or unsubstituted $C_6$ to $C_{18}$ arylene;
- $R^6$ is selected from the group consisting of phenylene and pyrazinylene;
- $R^7$ is unsubstituted $C_6$ to $C_{18}$ aryl;
- $R^8$ to $R^{11}$ are independently selected from the group consisting of H and unsubstituted $C_6$ to $C_{18}$ aryl;
- in case that one or more of $R^1$ to $R^5$ is substituted, the one or more substituents are independently $C_1$ to $C_6$ alkyl; and
- at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.

The compound of formula (I) may comprise 7 or more and 12 or less aromatic and heteroaromatic rings in total, especially may not comprise more than 12 aromatic and heteroaromatic rings in total. The compound of formula (I) may comprise 8 or more and 11 or less aromatic and heteroaromatic rings in total, especially may not comprise more than 11 aromatic and heteroaromatic rings in total.

The compound of formula (I) may comprise 1 or more and 3 or less heteroaromatic rings in total, especially may not comprise more than 3 aromatic and heteroaromatic rings in total. The compound of formula (I) may comprise 1 or 2 heteroaromatic rings in total, especially may not comprise more than 2 heteroaromatic rings in total.

The compound of formula (I) may have a molecular weight of 600 g/mol or more and 1,200 g/mol or less, of 600 g/mol or more and 1,000 g/mol or less, or of 600 g/mol or more and 900 g/mol or less, such as from about 640 g/mol to 880 g/mol.

It may be provided that the compound of formula (I) does not comprise a triaryl-amine moiety and does not comprise a carbazole-moiety.

The compound of formula (I) may have a triplet T1 level of 1.5 eV or more, such as of 1.5 eV or more and 3.0 eV or

less.

The compound of formula (I) may have a LUMO energy level of -2.0 eV or more and -1.6 eV or less, of -1.9 eV or more and -1.7 eV or less, or of -1.85 eV or more and -1.7 eV or less.

The compound of formula (I) may have a HOMO energy level of -5.90 eV or more and -5.10 eV or less, such as from -5.85 eV or more and -5.60 eV or less

The compound of formula (I) may have a band gap of 3.20 eV or more and 4.10 eV or less, or 3.29 eV or more and 4.07 eV or less, such as 3.73 eV or more and 4.07 eV or less.

The compound of formula (I) may have a dipole moment of 0 or more and 2 D or less, such as of 1.8 D or more and 1.21 D or less.

The compound of formula (I) may have a glass transition temperature (Tg) of 90 °C or more and 160°C or less, such as of 98 °C or more and 150°C or less.

The compound of formula (I) may be selected from E-1 to E-10

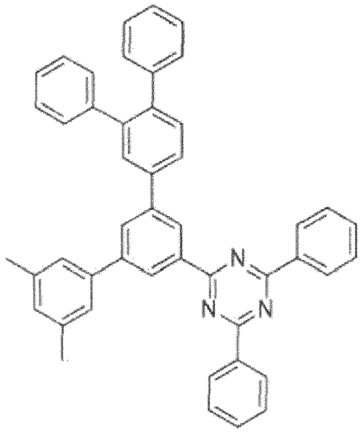

E-1

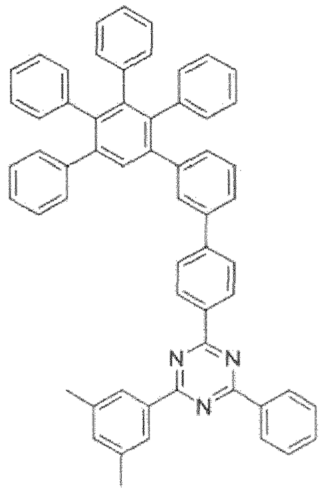

E-2

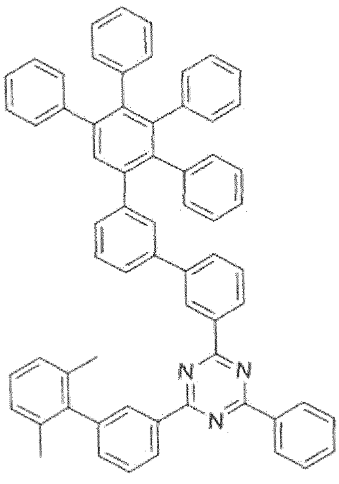

E-3

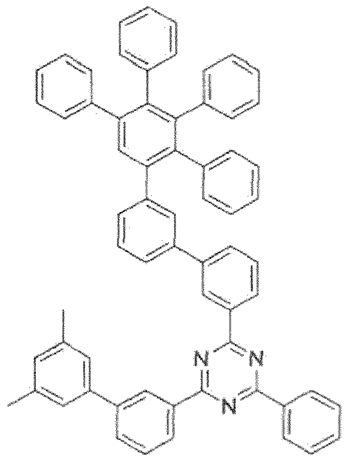

E-4

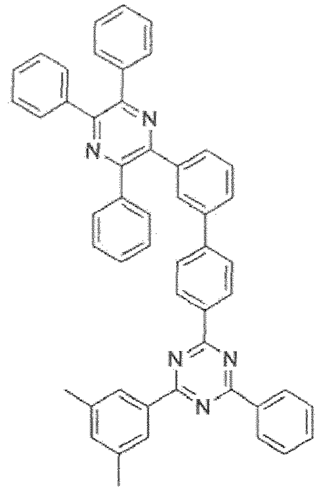 E-5 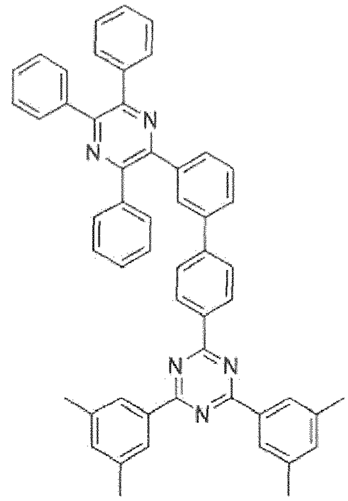 E-6 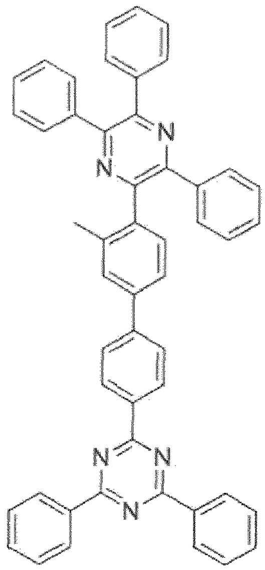 E-7

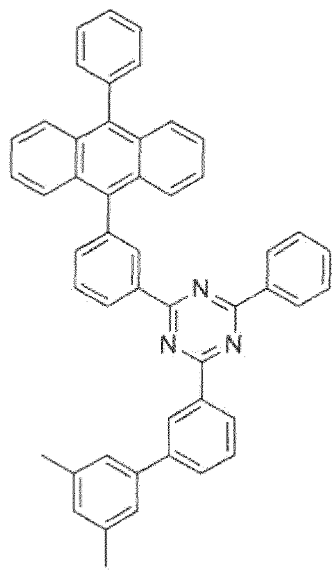 E-8 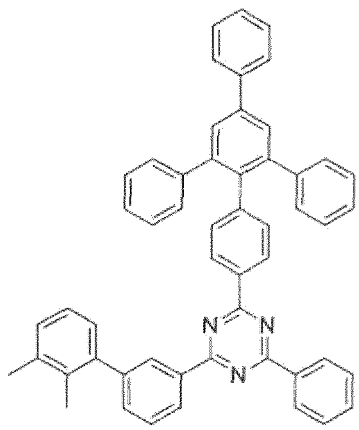 E-9

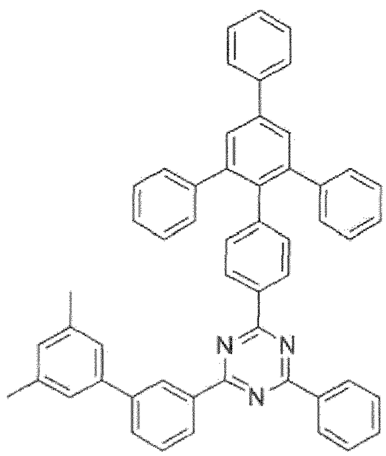 E-10.

Organic light emitting device

The organic light emitting device in accordance with the invention comprises an anode, a cathode, an emission

layer, a hole blocking layer, and an electron transport layer.

The organic light emitting device may be an organic light emitting diode. The organic light emitting diode may be a single stack organic light emitting diode or a multi-stack organic light emitting diode.

*Hole blocking layer*

The organic light emitting device comprises a hole blocking layer, wherein the hole blocking layer is arranged between the emission layer and the electron transport layer. The hole blocking layer may also be referred to as auxiliary electron transport layer.

The hole blocking layer may comprise the compound of formula (I) in accordance with the invention in an amount of at least 50 wt.-% with respect to the total weight of the hole blocking layer. The hole blocking layer may comprise the compound of formula (I) in accordance with the invention in an amount of at least 60 wt.-% with respect to the total weight of the hole blocking layer. The hole blocking layer may comprise the compound of formula (I) in accordance with the invention in an amount of at least 70 wt.-% with respect to the total weight of the hole blocking layer. The hole blocking layer may comprise the compound of formula (I) in accordance with the invention in an amount of at least 80 wt.-% with respect to the total weight of the hole blocking layer. The hole blocking layer may comprise the compound of formula (1) in accordance with the invention in an amount of at least 90 wt.-% with respect to the total weight of the hole blocking layer. The hole blocking layer may comprise the compound of formula (I) in accordance with the invention in an amount of at least 95 wt.-% with respect to the total weight of the hole blocking layer. The hole blocking layer may comprise the compound of formula (I) in accordance with the invention in an amount of at least 98 wt.-% with respect to the total weight of the hole blocking layer. The hole blocking layer may comprise the compound of formula (I) in accordance with the invention in an amount of at least 99 wt.-% with respect to the total weight of the hole blocking layer. The hole blocking layer may consist of the compound of formula (I) (or a mixture of two or more compounds falling within the definition of formula (I)).

The hole blocking layer is in direct contact with the electron transport layer. The hole blocking layer may be in direct contact with the emission layer. The hole blocking layer may be contacting sandwiched between the emission layer and the electron transport layer.

The hole blocking layer does not comprise an electrical dopant, that is, is free of an electrical dopant, such as an n-type dopant, especially a redox n-type dopant.

The term "free of" in this regard does not exclude impurities. Impurities have no technical effect with respect to the object achieved by the present invention. Impurities are not deliberately added to the layer during processing.

The term "free of" a compound means that such compound is not deliberately added to the layer during processing.

Under electrical dopant, especially n-type dopant it is understood a compound which, if embedded into an electron transport matrix, improves, in comparison with the neat matrix under the same physical conditions, the electron properties of the formed organic material, particularly in terms of electron injection and/or electron conductivity.

In the context of the present invention "embedded into an electron transport matrix" means homogenously mixed with the electron transport matrix.

The electrical dopant as referred to herein is especially selected from elemental metals, metal salts, metal complexes and organic radicals.

In one embodiment, the electrical dopant is selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,

- the lithium complex has the formula II, III or IV:

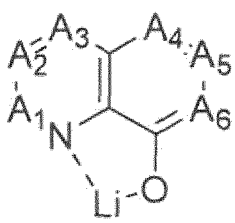 (II), 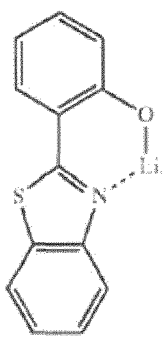 (III), 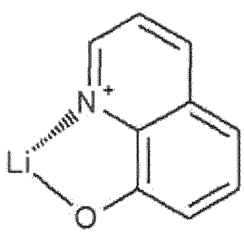 (IV)

wherein

$A_1$ to $A_6$ are same or independently selected from CH, CR, N, O;

R is same or independently selected from hydrogen, halogen, alkyl or aryl or heteroaryl with 1 to 20 carbon atoms; and more preferred $A_1$ to $A_6$ are CH,

- the borate based organic ligand is a tetra(1H-pyrazol-1-yl)borate,
- the phenolate is a 2-(pyridin-2-yl)phenolate, a 2-(diphenylphosphoryl)phenolate, an imidazol phenolate, 2-(pyridin-2-yl)phenolate or 2-(1-phenyl-1H-benzo[d]imidazol-2-yl)phenola te,
- the pyridinolate is a 2-(diphenylphosphoryl)pyridin-3-olate,
- the lithium Schiff base has the structure 100, 101, 102 or 103:

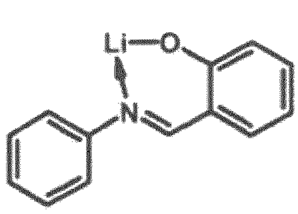

100

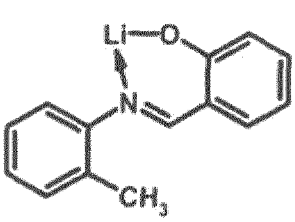

101

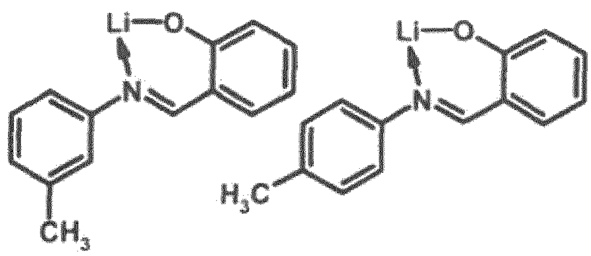

102 103

According to one embodiment of the invention, the hole blocking layer of the present invention is free of a lithium organic complex, alternatively 8-hydroxyquinolinolato-lithium (= LiQ).

According to one embodiment of the present invention the hole blocking layer is free of a metal, preferably selected from alkali metals, alkaline earth metals, rare earth metals and metals of the first transition period Ti, V, Cr and Mn, especially selected from Li, Na, K, Rb, Cs, Mg, Ca, Sr, Ba, Sm, Eu, Tm, Yb; more preferably from Li, Na, K, Rb, Cs, Mg and Yb, even more preferably from Li, Na, Cs and Yb, most preferably from Li, Na and Yb.

The most practical benchmark for the strength of an n-dopant is the value of its redox potential. There is no particular limitation in terms how negative the value of the redox potential can be.

As reduction potentials of usual electron transport matrices used in organic semiconductors are, if measured by cyclic voltammetry against ferrocene/ferrocenium reference redox couple, roughly in the range from about - 0.8 V to about - 3.1V; the practically applicable range of redox potentials for n-type dopants which can effectively n-dope such matrices is in a slightly broader range, from about - 0.5 to about - 3.3 V.

The measurement of redox potentials is practically performed for a corresponding redox couple consisting of the reduced and of the oxidized form of the same compound.

In case that the n-type dopant is an electrically neutral metal complex and/or an electrically neutral organic radical, the measurement of its redox potential is actually performed for the redox couple formed by

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

Preferably, the redox potential of the electrically neutral metal complex and/or of the electrically neutral organic radical may have a value which is more negative than - 0.5 V, preferably more negative than - 1.2 V, more preferably more negative than - 1.7 V, even more preferably more negative than - 2.1 V, most preferably more negative than - 2.5 V, if measured by cyclic voltammetry against ferrocene/ferrocenium reference redox couple for a corresponding redox couple consisting of

(i) the electrically neutral metal complex and its cation radical formed by an abstraction of one electron from the electrically neutral metal complex, or

(ii) the electrically neutral organic radical and its cation formed by an abstraction of one electron from the electrically neutral organic radical.

In a preferred embodiment, the redox potential of the n-dopant is between the value which is about 0.5 V more positive and the value which is about 0.5 V more negative than the value of the reduction potential of the chosen electron transport matrix.

Electrically neutral metal complexes suitable as n-type dopants may be e.g. strongly reductive complexes of some transition metals in low oxidation state. Particularly strong n-type dopants may be selected for example from Cr(II), Mo(II) and/or W(II) guanidinate complexes such as $W_2(hpp)_4$, as described in more detail in WO2005/086251.

Electrically neutral organic radicals suitable as n-type dopants may be e.g. organic radicals created by supply of additional energy from their stable dimers, oligomers or polymers, as described in more detail in EP 1 837 926 B1, WO2007/107306, or WO2007/107356. Under an elemental metal, it is understood a metal in a state of a neat metal, of a metal alloy, or in a state of free atoms or metal clusters. It is understood that metals deposited by vacuum thermal evaporation from a metallic phase, e.g. from a neat bulk metal, vaporize in their elemental form. It is further understood that if the vaporized elemental metal is deposited together with a covalent matrix, the metal atoms and/or clusters are embedded in the covalent matrix. In other words, it is understood that any metal-doped covalent material prepared by vacuum thermal evaporation contains the metal at least partially in its elemental form.

For the use in consumer electronics, only metals containing stable nuclides or nuclides having very long halftime of radioactive decay might be applicable. As an acceptable level of nuclear stability, the nuclear stability of natural potassium can be taken.

In one embodiment, the electrical dopant absent in the hole blocking is electropositive metals selected from alkali metals, alkaline earth metals, rare earth metals and metals of the first transition period Ti, V, Cr and Mn. Preferably, the n-dopant may be selected from Li, Na, K, Rb, Cs, Mg, Ca, Sr, Ba, Sm, Eu, Tm, Yb; more preferably from Li, Na, K, Rb, Cs, Mg and Yb, even more preferably from Li, Na, Cs and Yb, most preferably from Li, Na and Yb.

The hole blocking layer may have a thickness of < 50 nm, optionally between 1 and 30 nm, optionally between 1 and 10 nm, optionally between 1 and 5 nm.

*Further layers*

In accordance with the invention, the organic light emitting device may comprise, besides the layers already mentioned above, further layers. Exemplary embodiments of respective layers are described in the following:

*Substrate*

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate or a silicon substrate. It may be provided that the substrate is a non-transparent substrate.

*Anode electrode*

The inventive organic light emitting device comprises an anode (anode electrode). The anode electrode may be formed by depositing or sputtering a material that is used to form the anode electrode. The material used to form the anode electrode may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide ($SnO_2$), aluminum zinc oxide (AlZO) and zinc oxide (ZnO), may be used to form the anode electrode. The anode electrode may also be formed using metals, typically silver (Ag), gold (Au), or metal alloys.

*Hole injection layer*

A hole injection layer (HIL) may be formed on the anode electrode by vacuum deposition, spin coating, printing, casting, slot-die coating, Langmuir-Blodgett (LB) deposition, or the like. When the HIL is formed using vacuum deposition, the deposition conditions may vary according to the compound that is used to form the HIL, and the desired structure and thermal properties of the HIL. In general, however, conditions for vacuum deposition may include a deposition temperature of 100° C to 500° C, a pressure of 10-8 to 10-3 Torr (1 Torr equals 133.322 Pa), and a deposition rate of 0.1 to 10 nm/sec.

When the HIL is formed using spin coating or printing, coating conditions may vary according to the compound that is used to form the HIL, and the desired structure and thermal properties of the HIL. For example, the coating conditions may include a coating speed of about 2000 rpm to about 5000 rpm, and a thermal treatment temperature of about 80° C to about 200° C. Thermal treatment removes a solvent after the coating is performed.

The HIL may be formed of any compound that is commonly used to form a HIL. Examples of compounds that may be used to form the HIL include a phthalocyanine compound, such as copper phthalocyanine (CuPc), 4,4',4"-tris (3-methylphenylphenylamino) triphenylamine (m-MTDATA), TDATA, 2T-NATA, polyaniline/dodecylbenzenesulfonic acid (Pani/DBSA), poly(3,4-ethylenedioxythiophene)/poly(4-styrenesulfonate) (PEDOT/PSS), polyaniline/camphor sulfonic acid (Pani/CSA), and polyaniline)/poly(4-styrenesulfonate (PANI/PSS).

The HIL may comprise or consist of p-type dopant and the p-type dopant may be selected from tetrafluoro-tetracyanoquinonedimethane ($F_4$TCNQ), 2,2'-(perfluoronaphthalen-2,6-diylidene) dimalononitrile or 2,2',2"-(cyclopropane-1,2,3-triylidene)tris(2-(p-cyanotetrafluorophenyl)acetonitrile) but not limited hereto. The HIL may be selected from a hole-transporting matrix compound doped with a p-type dopant. Typical examples of known doped hole transport materials are: copper phthalocyanine (CuPc), which HOMO level is approximately -5.2 eV, doped with tetrafluoro-tetracyanoquinonedimethane ($F_4$TCNQ), which LUMO level is about -5.2 eV; zinc phthalocyanine (ZnPc) (HOMO = -5.2 eV) doped with $F_4$TCNQ; $\alpha$-NPD (N,N'-Bis(naphthalen-1-yl)-N,N'-bis(phenyl)-benzidine) doped with $F_4$TCNQ. $\alpha$-NPD doped with 2,2'-(perfluoronaphthalen-2,6-diylidene) dimalononitrile. The p-type dopant concentrations can be selected from 1 to 20 wt.-%, more preferably from 3 wt.-% to 10 wt.-%.

The thickness of the HIL may be in the range from about 1 nm to about 100 nm, and for example, from about 1 nm to about 25 nm. When the thickness of the HIL is within this range, the HIL may have excellent hole injecting characteristics, without a substantial penalty in driving voltage.

*Hole transport layer*

A hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

*Electron blocking layer*

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

*Emission layer (EML)*

The emission layer in the organic light emitting device in accordance with the invention may be a blue emission layer or a green emission layer.

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

It may be provided that the emission layer does not comprise the compound of Formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc ($Zn(BTZ)_2$).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, $Ir(piq)_3$, and $Btp_2Ir(acac)$, but are not limited thereto. These compounds are phosphorescent emitters, however, fluorescent red emitter dopants could also be used.

Examples of phosphorescent green emitter dopants are $Ir(ppy)_3$ (ppy = phenylpyridine), $Ir(ppy)_2(acac)$, $Ir(m-pyp)_3$.

Examples of phosphorescent blue emitter dopants are $F_2Irpic$, $(F_2ppy)_2Ir(tmd)$ and $Ir(dfppz)_3$ and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

*Hole blocking layer (HBL)*

Especially if the organic light emitting device is a tandem OLED or another device comprising multiple layer stacks, the organic light emitting device may comprise more than one hole transport layer, that is, one or more additional hole transport layer(s).

The hole blocking layer(s) may be the hole blocking layer as defined above. Alternatively, for additional HBLs, any compound that is commonly used to form a HBL may be used. Examples of compounds for forming the HBL include oxadiazole derivatives, triazole derivatives, and phenanthroline derivatives.

The hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may have a thickness in the range from about 5 nm to about 100 nm, for example, from about 5 nm to about 30 nm. When the thickness of the HBL is within this range, the HBL may have excellent hole-blocking properties, without a substantial penalty in driving voltage.

*Electron transport layer (ETL)*

The OLED according to the present invention comprises an electron transport layer (ETL).

By suitably adjusting energy levels of particular layers of the ETL, the injection and transport of the electrons may be controlled, and the holes may be efficiently blocked. Thus, the OLED may have long lifetime.

The electron transport layer may comprise ETM materials known in the art. Suitable compounds for the ETM are not particularly limited.

It may be provided that the ETL comprises an electron transport matrix compound and an electrical dopant.

In one embodiment, the electron transport matrix compounds consist of covalently bound atoms. Preferably, the electron transport matrix compound comprises a conjugated system of at least 6, more preferably of at least 10 delocalized electrons. In one embodiment, the conjugated system of delocalized electrons may be comprised in aromatic or heteroaromatic structural moieties, as disclosed e.g. in documents EP 1 970 371 A1 or WO 2013/079217 A1.

The ETL may comprise an electrical dopant, such as an n-type dopant, especially a redox n-type dopant.

Under electrical dopant, especially n-type dopant it is understood a compound which, if embedded into an

electron transport matrix, improves, in comparison with the neat matrix under the same physical conditions, the electron properties of the formed organic material, particularly in terms of electron injection and/or electron conductivity.

In the context of the present invention "embedded into an electron transport matrix" means homogenously mixed with the electron transport matrix.

The electrical dopant may be selected from elemental metals, metal salts, metal complexes and organic radicals.

In one embodiment, the electrical dopant is selected from alkali metal salts and alkali metal complexes; preferably from lithium salts and lithium organic complexes; more preferably from lithium halides and lithium organic chelates; even more preferably from lithium fluoride, a lithium quinolinolate, lithium borate, lithium phenolate, lithium pyridinolate or from a lithium complex with a Schiff base ligand; most preferably,

- the lithium complex has the formula II, III or IV:

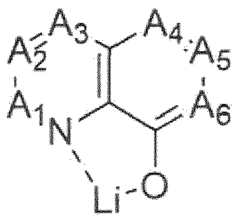 (II), 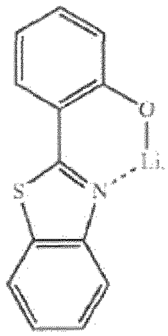 (III), 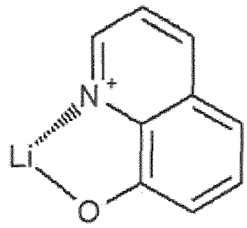 (IV)

wherein

$A_1$ to $A_6$ are same or independently selected from CH, CR, N, O;

R is same or independently selected from hydrogen, halogen, alkyl or aryl or heteroaryl with 1 to 20 carbon atoms; and more preferred $A_1$ to $A_6$ are CH,

- the borate based organic ligand is a tetra(1H-pyrazol-1-yl)borate,
- the phenolate is a 2-(pyridin-2-yl)phenolate, a 2-(diphenylphosphoryl)phenolate, an imidazol phenolate, 2-(pyridin-2-yl)phenolate or 2-(1-phenyl-1H-benzo[d]imidazol-2-yl)phenolate,
- the pyridinolate is a 2-(diphenylphosphoryl)pyridin-3-olate,
- the lithium Schiff base has the structure 100, 101, 102 or 103:

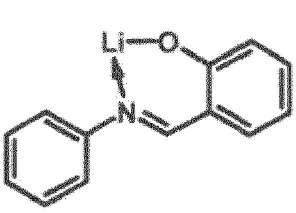 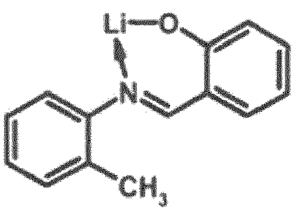 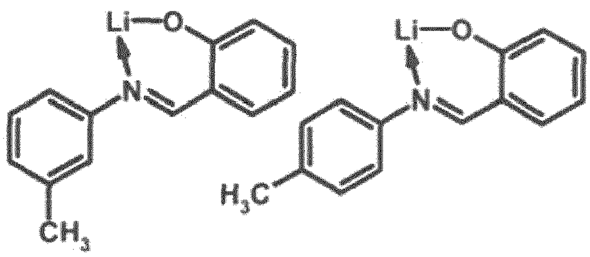

100 101 102 103

According to one embodiment of the invention, electrical dopant is a lithium organic complex, such as 8-hydroxyquinolinolato-lithium (= LiQ).

It may be provided that the ETL is free of the compound of formula (I)

*Electron injection layer (EIL)*

An EIL, which may facilitate injection of electrons from the cathode into the electron transport layer stack, may be

formed on the electron transport layer, preferably directly on the electron transport layer. Examples of materials for forming the EIL or being comprised in the EIL include lithium 8-hydroxyquinolinolate (LiQ), LiF, NaCl, CsF, $Li_2O$, BaO, Ca, Ba, Yb, Mg which are known in the art. Deposition and coating conditions for forming the EIL are similar to those for formation of the HIL, although the deposition and coating conditions may vary, according to the material that is used to form the EIL. The EIL may comprise an organic matrix material doped with an n-type dopant. The matrix material may be selected from materials conventionally used as matrix materials for electron transport layers.

The EIL may consist of a number of individual EIL sublayers. In case the EIL consists of a number of individual EIL sublayers, the number of sublayers is preferably 2. The individual EIL sublayers may comprise different materials for forming the EIL.

The thickness of the EIL may be in the range from about 0.1 nm to about to nm, for example, in the range from about 0.5 nm to about 9 nm. When the thickness of the EIL is within this range, the EIL may have satisfactory electron-injecting properties, without a substantial penalty in driving voltage.

It may be provided that the electron injection layer does not comprise the compound of formula (I).

*Cathode electrode*

The cathode (cathode electrode) is formed on the EIL (if present) or on the ETL, preferably directly on the EIL, preferably in direct contact with the EIL. In the sense of this invention the cathode and the EIL can be regarded as one functional part enabling the injection of electrons into the electron transport layer stack. The cathode electrode may be formed of a metal, an alloy, an electrically conductive compound, or a mixture thereof. The cathode electrode may have a low work function. For example, the cathode electrode may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like, for example an alloy of Ag and Mg, such as Ag:Mg 90:10 wt/wt. Alternatively, the cathode electrode may be formed of a transparent conductive oxide, such as ITO or IZO.

The thickness of the cathode electrode may be in the range from about 5 nm to about 1000 nm, for example, in the range from about 10 nm to about 100 nm. When the thickness of the cathode electrode is in the range from about 5 nm to about 50 nm, the cathode electrode may be transparent or semitransparent even if formed from a metal or metal alloy. The transparent or semitransparent cathode may facilitate light emission through the cathode.

*Charge generation layer (CGL)*

The charge generation layer (CGL) may comprise a p-type charge generation layer (p-CGL) and an n-type charge generation layer (n-CGL). An interlayer may be arranged between the p-CGL and the -n-CGL.

Typically, the charge generation layer is a p-n junction joining an n-type charge generation layer (electron generating layer) and a hole generating layer. The n-side of the p-n junction generates electrons and injects them into the layer that is adjacent in the direction to the anode. Analogously, the p-side of the p-n junction generates holes and injects them into the layer that is adjacent in the direction to the cathode.

Charge generating layers are used in tandem and stacked devices, for example, in tandem or stacked OLEDs comprising, between two electrodes, two or more emission layers. In a tandem or stacked OLED comprising two emission layers, the n-type charge generation layer provides electrons for the first light emission layer arranged near the anode, while the hole generating layer provides holes to the second light emission layer arranged between the first emission layer and the cathode.

Suitable matrix materials for the hole generating layer may be materials conventionally used as hole injection and/or hole transport matrix materials. Also, p-type dopant used for the hole generating layer can employ conventional materials. For example, the p-type dopant can be one selected from a group consisting of tetrafluoro-7,7,8,8-tetracyanoquinodimethane ($F_4$-TCNQ), derivatives of tetracyanoquinodimethane, radialene derivatives, iodine, $FeCl_3$, $FeF_3$, and $SbCl_5$. Also, the host can be one selected from a group consisting of N,N'-di(napthalen-1-yl)-N,N-diphenyl-benzidine (NPB), N,N'-diphenyl-N,N'-bis(3-methylphenyl)-1,1-biphenyl-4,4'-diamine (TPD) and N,N',N'-tetranaphthyl-benzidine (TNB). The p-type charge generation layer may consist of CNHAT.

The n-type charge generating layer may be the layer comprising the compound of Formula (I). The n-type charge generation layer can be layer of a neat n-type dopant, for example of a metal, or can consist of an organic matrix material doped with the n-type dopant. In one embodiment, the n-type dopant can be alkali metal, alkali metal compound, alkaline earth metal, alkaline earth metal compound, a transition metal, a transition metal compound or a rare earth metal. In another embodiment, the metal can be one selected from a group consisting of Li, Na, K, Rb, Cs, Mg, Ca, Sr, Ba, La, Cc, Sm, Eu, Tb, Dy, and Yb. More specifically, the n-type dopant can be one selected from a group consisting of Li, Cs, K, Rb, Mg, Na, Ca, Sr, Eu and Yb. Suitable matrix materials for the electron generating layer may be the materials conventionally used as matrix materials for electron injection or electron transport layers. The matrix material can be for example one selected from a group consisting of triazine compounds, hydroxyquinoline derivatives like tris(8-hydroxyquinoline)aluminum, benzazole derivatives, and silole derivatives.

According to one aspect of the present invention, an electron transport layer comprising the compound of formula (I) is arranged between a first and a second emission layer and a further electron transport layer comprising the compound of formula (I) is arranged between the second emission layer and the cathode.

According to another aspect of the present invention, there is provided an OLED comprising: a substrate; an anode electrode formed on the substrate; a hole injection layer, a hole transport layer, an electron blocking layer, an emission layer, an auxiliary electron transport layer, an electron transport layer comprising the compound of formula (I) and a cathode electrode.

According to another aspect of the present invention, there is provided an OLED comprising: a substrate; an anode electrode formed on the substrate; a hole injection layer, a hole transport layer, an electron blocking layer, an emission layer, a auxiliary electron transport layer layer, an electron transport layer comprising the compound of formula (I), an electron injection layer, and a cathode electrode.

According to various embodiments of the present invention, there may be provided OLEDs layers arranged between the above mentioned layers, on the substrate or on the top electrode.

In one embodiment, the organic light emitting device according to the invention further comprises a layer comprising a radialene compound and/or a quinodimethane compound.

In one embodiment, the radialene compound and/or the quinodimethane compound may be substituted with one or more halogen atoms and/or with one or more electron withdrawing groups. Electron withdrawing groups can be selected from nitrile groups, halogenated alkyl groups, alternatively from perhalogenated alkyl groups, alternatively from perfluorinated alkyl groups. Other examples of electron withdrawing groups may be acyl, sulfonyl groups or phosphoryl groups.

Alternatively, acyl groups, sulfonyl groups and/or phosphoryl groups may comprise halogenated and/or perhalogenated hydrocarbyl. In one embodiment, the perhalogenated hydrocarbyl may be a perfluorinated hydrocarbyl. Examples of a perfluorinated hydrocarbyl can be perfluormethyl, perfluorethyl, perfluorpropyl, perfluorisopropyl, perfluorobutyl, perfluorophenyl, perfluorotolyl; examples of sulfonyl groups comprising a halogenated hydrocarbyl may be trifluoromethylsulfonyl, pentafluoroethylsulfonyl, pentafluorophenylsulfonyl, heptafluoropropylsufonyl, nonafluorobutylsulfonyl, and like.

In one embodiment, the radialene and/or the quinodimethane compound may be comprised in a hole injection, hole transporting and/or a hole generation layer.

In one embodiment, the radialene compound may have Formula (XX) and/or the quinodimethane compound may have Formula (XXIa) or (XXIb):

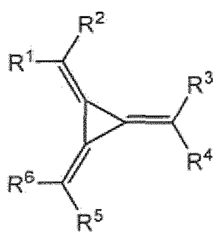
(XX)
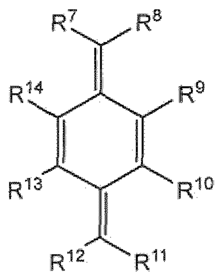
(XXIa)
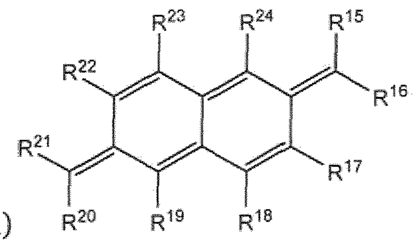
(XXIb),

wherein (as an exception different to the description above) $R^1$, $R^2$, $R^3$, $R^4$, $R^5$, $R^6$, $R^7$, $R^8$, $R^{11}$, $R^{12}$, $R^{15}$, $R^{16}$, $R^{20}$, $R^{21}$ are independently selected from above mentioned electron withdrawing groups and $R^9$, $R^{10}$, $R^{13}$, $R^{14}$, $R^{17}$, $R^{18}$, $R^{19}$, $R^{22}$, $R^{23}$ and $R^{24}$ are independently selected from H, halogen and above mentioned electron withdrawing groups.

<u>Process for preparing the organic light emitting device</u>

According to a further aspect, the invention is related to a process for preparing the organic light emitting device according to the present invention, wherein the process comprises a step of depositing the compound of formula (I) according to the present invention on a solid support.

The method for depositing may comprise:

- deposition via vacuum thermal evaporation;
- deposition via solution processing, preferably the processing is selected from spin-coating, printing, casting; and/or

- slot-die coating.

Device

According to a further aspect, the invention is related to a display device or a lighting device comprising the organic light emitting device according to the invention, preferably comprises at least two organic light emitting devices according to the invention.

The display device may be a television, a tablet, or a mobile phone.

Compound of formula (II)

According to a further aspect, the invention is related to a compound of formula (II)

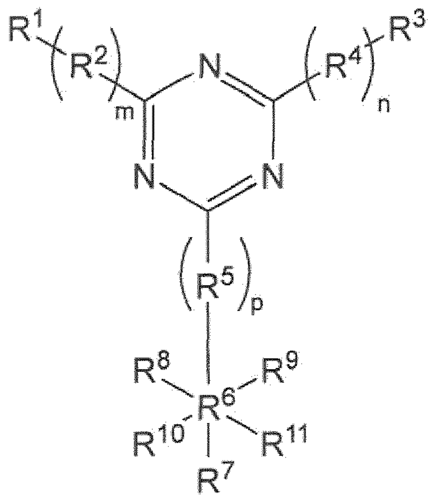

(II).

Especially, if not mentioned else explicitly, all compounds, especially the compound of formula (II), groups, moieties, substituents etc. shown herein, especially by structural formulas, by systematic names etc. encompass the respective partially and fully deuterated derivatives thereof, wherein it may be provided that substitution beyond deuteration is excluded. If a compound, group, moiety, substituent etc. is mentioned to be unsubstituted, this does not exclude substitution with deuterium.

m and n are independently o or 1.

p is o, 1 or 2.

$m + n + p \geq 1$. $(m + n + p)$ may be an integer from 1 to 4. $(m + n + p)$ may be an integer from 1 to 3. $(m + n + p)$ may be 1 or 2.

$R^1$ and $R^3$ are independently substituted or unsubstituted phenyl.

In case that one or more of $R^1$ and $R^3$ is substituted, the one or more substituents are independently $C_1$ to $C_6$ alkyl. In case that one or more of $R^1$ and $R^3$ is substituted, the one or more substituents may be independently $C_1$ to $C_5$ alkyl. In case that one or more of $R^1$ and $R^3$ is substituted, the one or more substituents may be independently $C_1$ to $C_4$ alkyl. In case that one or more of $R^1$ and $R^3$ is substituted, the one or more substituents may be independently $C_1$ to $C_3$ alkyl. In case that one or more of $R^1$ and $R^3$ is substituted, the one or more substituents may be independently $C_1$ to $C_2$ alkyl. In case that one or more of $R^1$ and $R^3$ is substituted, the one or more substituents may be each methyl.

In case that one or more of $R^1$ and $R^3$ is substituted, the respective $R^1$ and/or $R^3$ (including all substituents) may be independently selected from the following groups IIa-1 to IIa-8

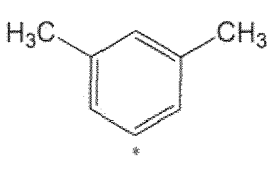 IIa-1 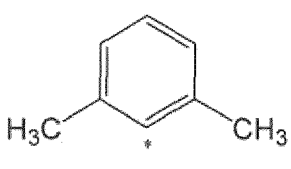 IIa-2 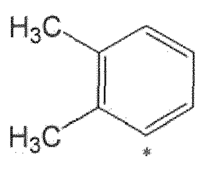 IIa-3

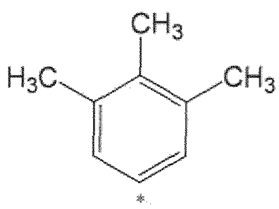
IIa-4
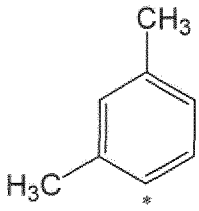
IIa-5
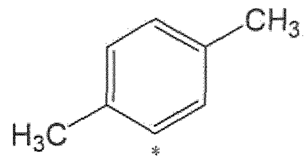
IIa-6

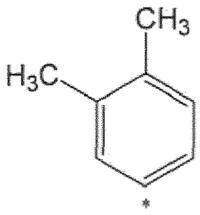
IIa-7
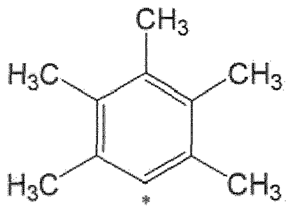
IIa-8

wherein "*" is the binding position, that is, the binding position to $R^2$ (for $R^1$) or $R^4$ (for $R^3$), in formula (II).

In case that one or more of $R^1$ and $R^3$ is substituted, the respective $R^1$ and/or $R^3$ (including all substituents) may be independently selected from the following groups IIa-1 to IIa-3.

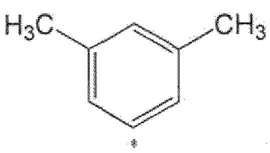
IIa-1
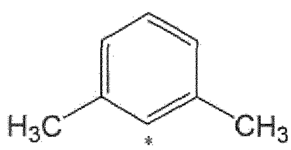
IIa-2
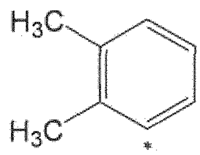
IIa-3

wherein "*" is the binding position, that is, the binding position to $R^2$ (for $R^1$) or $R^4$ (for $R^3$), in formula (II).

It may be provided that one or more of the $CH_3$ group(s) in IIa-1 to IIa-8 is replaced by $C_2$ to $C_6$ alkyl, $C_2$ to $C_4$ alkyl, $C_2$ to $C_3$ alkyl, or $C_2$ alkyl.

$R^2$ and $R^4$ are independently substituted or unsubstituted phenylene. $R^2$ and $R^4$ may be independently substituted or unsubstituted phenylene. $R^2$ and $R^4$ may be independently unsubstituted phenylene. $R^2$ and $R^4$ may be each unsubstituted meta-phenylene.

If p is 1, $R^5$ may be selected from the following groups IIb-1 and IIb-2

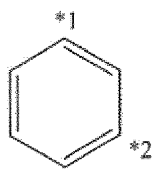
IIb-1
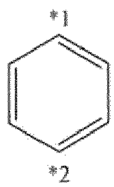
IIb-2

wherein one "*1" is the binding position to

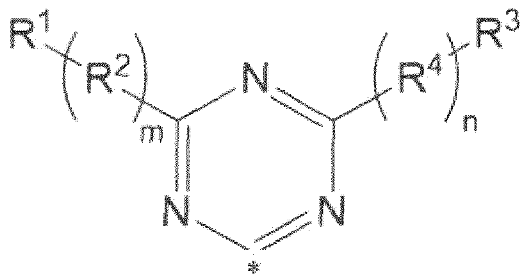

and "*2" is the binding position to $R^6$ in formula (II), wherein the respective IIb-1 to IIb-6 can be substituted or unsubstituted.

If p is 2, the two $R^5$ may form together a moiety IIb-3 to IIb-5

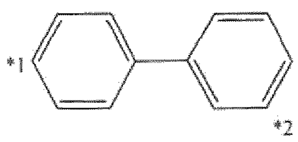 IIb-3 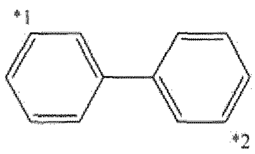 IIb-4 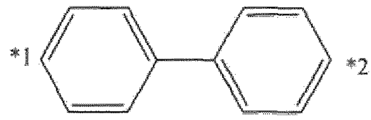 IIb-5

wherein one "*1" is the binding position to

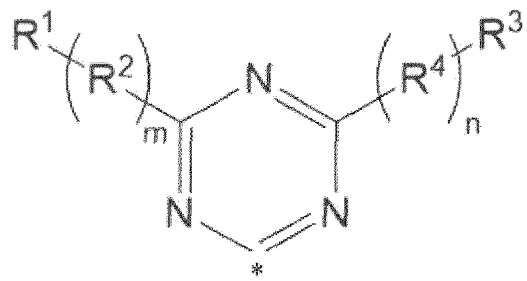

and "*2" is the binding position to $R^6$ in formula (II), wherein the respective IIb-3 to IIb-6 can be substituted or unsubstituted.

In case that one or more of $R^2$, $R^4$ and $R^5$ is substituted, the one or more substituents are independently $C_1$ to $C_6$ alkyl. In case that one or more of $R^2$, $R^4$ and $R^5$ is substituted, the one or more substituents may be independently $C_1$ to $C_5$ alkyl. In case that one or more of $R^2$, $R^4$ and $R^5$ is substituted, the one or more substituents may be independently $C_1$ to $C_4$ alkyl. In case that one or more of $R^2$, $R^4$ and $R^5$ is substituted, the one or more substituents may be independently $C_1$ to $C_3$ alkyl. In case that one or more of $R^2$, $R^4$ and $R^5$ is substituted, the one or more substituents may be independently $C_1$ to $C_2$ alkyl. In case that one or more of $R^2$, $R^4$ and $R^5$ is substituted, the one or more substituents may be each methyl.

In case that one or more of $R^2$, $R^4$ and $R^5$ is substituted, the respective $R^2$, $R^4$ and $R^5$ (including all substituents) may be independently selected from or comprise one of the following groups IIc-1 to IIc-9

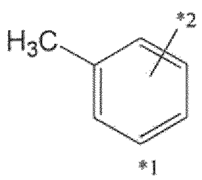 IIc-1 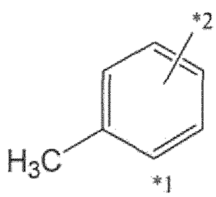 IIc-2 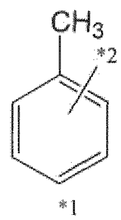 IIc-3 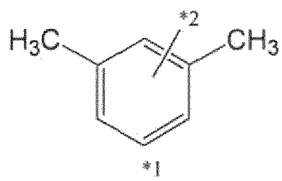 IIc-4

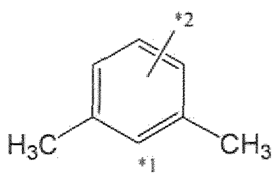 IIc-5 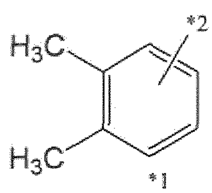 IIc-6 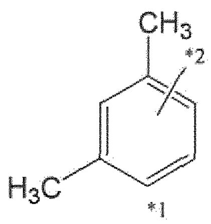 IIc-7

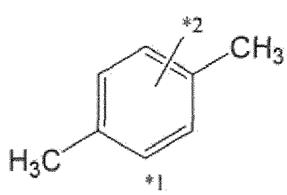 IIc-8 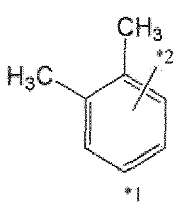 IIc-9

wherein "*1" and "*2" are the binding positions to the remaining part of formula (II).

Including all substituents (if any), $R^5$ may, if p = 1, be selected from one of the following groups IId-4 or IId-5; or, in case that p = 2, the two $R^5$ may combine to any of IId-1 to IId-3 (including all substituents)

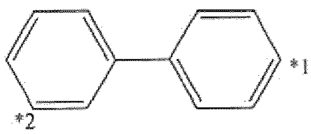 IId-1 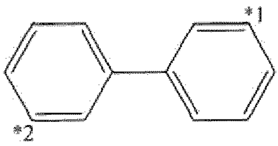 IId-2

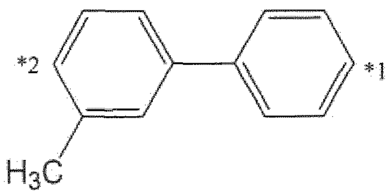 IId-3 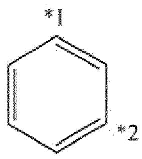 IId-4 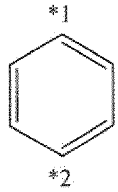 IId-5

wherein "*1" is the binding position to

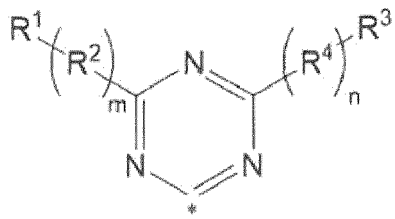

and "*2" is the binding position to $R^6$ in formula (II).

$R^6$ is selected from the group consisting of phenylene, pyrazinylene and anthracenylene. $R^6$ may selected from the group consisting of phenylene and pyrazinylene.

R6 may be selected from one of the following groups IIe-1 to IIe-7

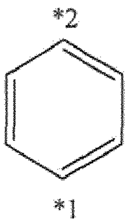 IIe-1 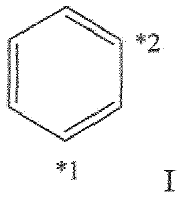 IIe-2 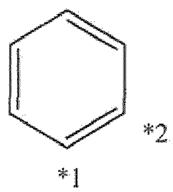 IIe-3 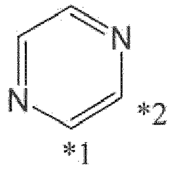 IIe-4 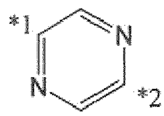 IIe-5

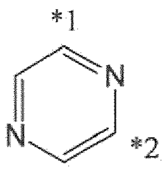 IIe-6 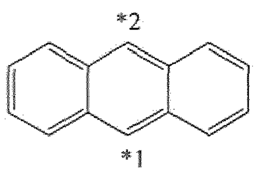 IIe-7

wherein "*1" is the binding position to $R^5$ and "*2" is the binding position to $R^7$ in formula (II).

$R^6$ may be selected from one of the following groups IIe-1 to IIe-6

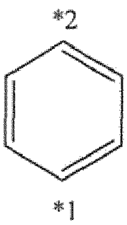 IIe-1 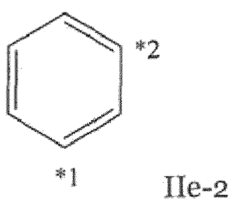 IIe-2 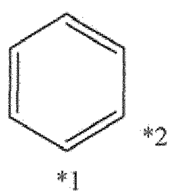 IIe-3 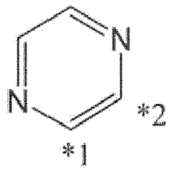 IIe-4 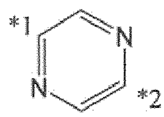 IIe-5

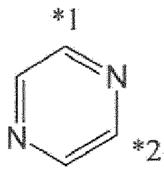

IIe-6

wherein "*1" is the binding position to $R^5$ and "*2" is the binding position to $R_7$ in formula (II).

In IIe-1 to IIe-7 $R^8$ to $R^{11}$ can be bonded to any carbon atom except for the carbon atoms labeled with "*1*" and "*2". If there are less than four carbon atoms to which $R^8$ to $R^{11}$ can be bonded one or more of $R^8$ to $R^{11}$ can be absent. For example, if there are only two carbon atoms to which $R^8$ to $R^{11}$ can be bonded, such as in IIe-4, $R^{10}$ and $R^{11}$ are absent and the respective group has the following formula IIe-4.1

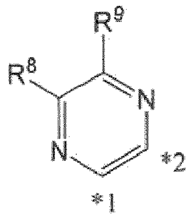

IIe-4.1.

$R^7$ is unsubstituted phenyl.

$R^8$ to $R^{11}$ are independently selected from the group consisting of H and unsubstituted phenyl.

If $R^6$ is phenylene, it can be proxided that 1, 2 or 3 of $R^8$ to $R^{11}$ are H and the remaining $R^8$ to $R^{11}$ are unsubstituted phenyl.

If $R^6$ is phenylene, it can be provided that at least one of $R^8$ to $R^{11}$ is unsubstituted phenyl and this unsubstituted phenyl is in ortho-position to the binding position of the phenylene ($R^6$) to R5.

If $R^6$ is phenylene, it can be provided that at least two of $R^8$ to $R^{11}$ are unsubstituted phenyl and these unsubstituted phenyls are in ortho-position with respect to each other.

The feature of at least one of $R^8$ to $R^{11}$ being aryl and being in ortho position to the binding position of the phenylene ($R^6$) to $R^5$ and the feature of at least two of $R^8$ to $R^{11}$ being phenyl and these phenyls being in ortho-position with respect to each other as described in the two foregoing paragraphs may apply alternatively or together (and/or).

If $R^6$ is phenylene, the moiety

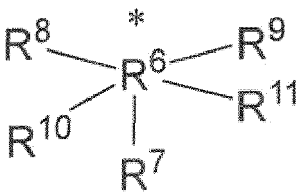

with "*" being the binding position to $R^5$ may be one of the following groups IIf-1 to IIf-3

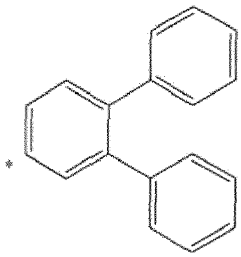

IIf-1

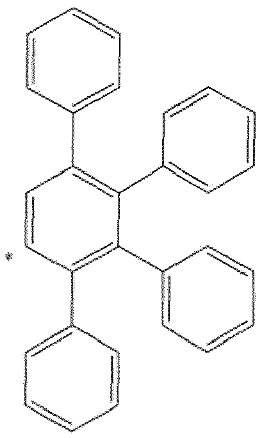

IIf-2

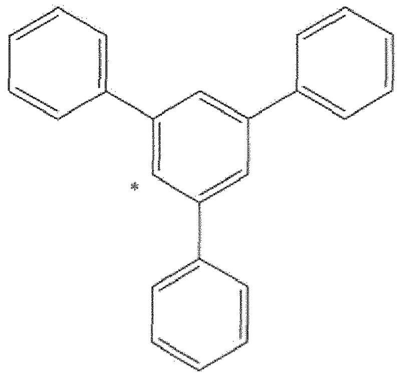

IIf-3.

If $R^6$ is pyrazinylene, the moiety

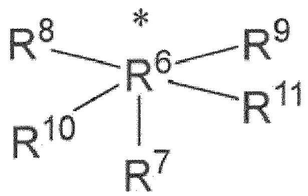

with "*" being the binding position to $R^5$ may be IIg-1

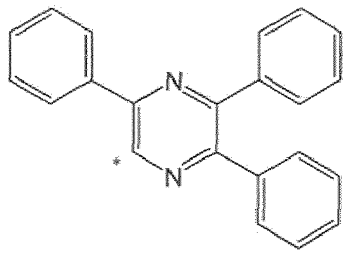

IIg-1.

If $R^6$ is anthracenylene, the moiety

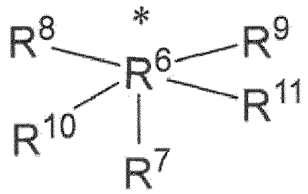

with "*" being the binding position to $R^5$ may be IIh-1

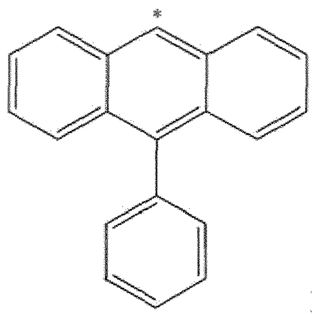

IIh-1.

At least one of $R^1$ and $R^3$ is substituted with at least one $C_1$ to $C_6$ alkyl substituent; and/or at least one of $R^2$, $R^4$ and $R^5$ is substituted with at least one $C_1$ to $C_6$ alkyl substituent. In one embodiment, at least one of $R^1$ and $R^3$ is substituted with at least one $C_1$ to $C_6$ alkyl substituent; and/or $R^5$ is substituted with at least one $C_1$ to $C_6$ alkyl substituent. In one embodiment, at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituent. In one embodiment, at least one of $R^1$ and $R^3$ is substituted with at least two $C_1$ to $C_6$ alkyl substituents; and/or $R^5$ is substituted with at least one $C_1$ to $C_6$ alkyl substituent. In one embodiment, at least one of $R^1$ and $R^3$ is substituted with one or two $C_1$ to $C_6$ alkyl substituent(s); and/or $R^5$ is substituted with one or two $C_1$ to $C_6$ alkyl substituent(s). In this regard, the $C_1$ to $C_6$ alkyl substituent can be independently selected as described above.

According to one embodiment, there is provided the compound of formula (II)

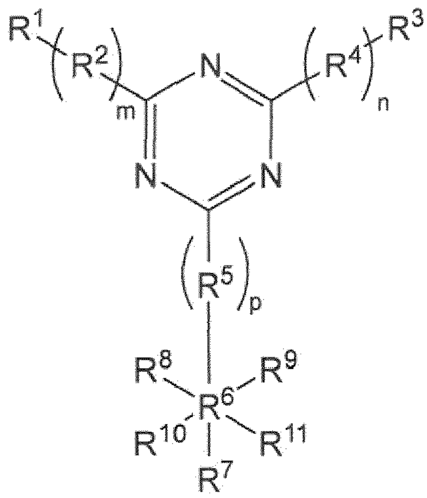

(II)

wherein in formula (II)

- m and n are independently 0 or 1;
- p is o, 1 or 2;
- m + n + p ≥ 1;
- $R^1$ and $R^3$ are independently substituted or unsubstituted phenyl;
- $R^2$ and $R^4$ are independently substituted or unsubstituted phenylene;
- each $R^5$ is independently substituted or unsubstituted phenylene;
- $R^6$ is selected from the group consisting of phenylene, pyrazinylene and anthracenylene;
- $R^7$ is unsubstituted phenyl;
- $R^8$ to $R^{11}$ are independently selected from the group consisting of H and unsubstituted phenyl;
- in case that one or more of $R^1$ to $R^5$ is substituted, the one or more substituents are independently $C_1$ to $C_6$ alkyl; and
- at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.

According to one embodiment, there is provided the compound of formula (II)

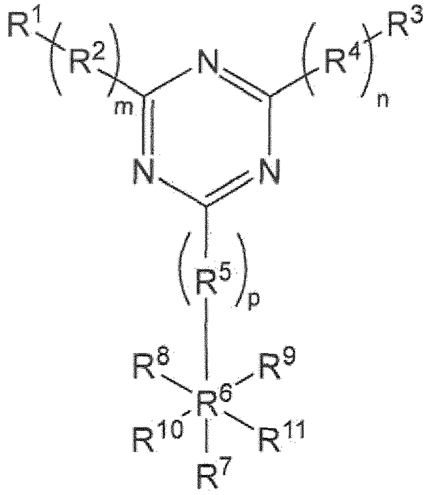

(II)

wherein in formula (II)

- m and n are independently o or 1;
- p is o, 1 or 2;
- m + n + p ≥ 1;
- $R^1$ and $R^3$ are independently substituted or unsubstituted phenyl;
- $R^2$ and $R^4$ are independently substituted or unsubstituted phenylene;
- each $R^5$ is independently substituted or unsubstituted phenylene;
- $R^6$ is selected from the group consisting of phenylene and pyrazinylene;
- $R^7$ is unsubstituted phenyl;
- $R^8$ to $R^{11}$ are independently selected from the group consisting of H and unsubstituted phenyl;
- in case that one or more of $R^1$ to $R^5$ is substituted, the one or more substituents are independently $C_1$ to $C_6$ alkyl; and
- at least one of $R^1$ and $R^3$ is substituted with at least one $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.

According to one embodiment, there is provided the compound of formula (II)

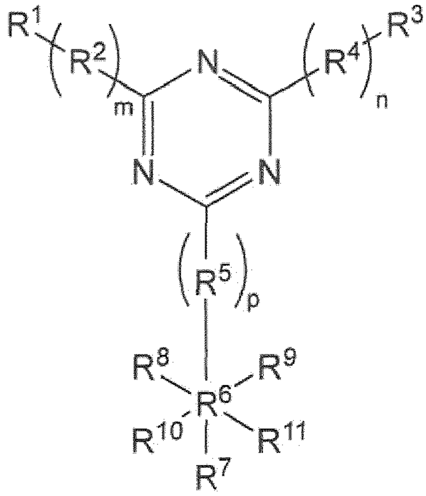

(II)

wherein in formula (II)

- m and n are independently o or 1;
- p is o, 1 or 2;
- m + n + p ≥ 1;
- $R^1$ and $R^3$ are independently substituted or unsubstituted phenyl;
- $R^2$ and $R^4$ are independently substituted or unsubstituted phenylene;
- each $R^5$ is independently substituted or unsubstituted phenylene;
- $R^6$ is selected from the group consisting of phenylene and pyrazinylene;
- $R^7$ is unsubstituted phenyl;
- $R^8$ to $R^{11}$ are independently selected from the group consisting of H and unsubstituted phenyl;
- in case that one or more of $R^1$ to $R^5$ is substituted, the one or more substituents are independently $C_1$ to $C_6$ alkyl; and
- at least one of $R^1$ and $R^3$ is substituted with at least two $C_1$ to $C_6$ alkyl substituents; and/or at least one of $R^2$, $R^4$ and $R^5$ is substituted with at least one $C_1$ to $C_6$ alkyl substituents.

m, n, p and $R^1$ to $R^{11}$ in this embodiment can be as described above.

The compound of formula (II) may comprise 7 or more and 12 or less aromatic and heteroaromatic rings in total, especially may not comprise more than 12 aromatic and heteroaromatic rings in total. The compound of formula (II) may comprise 8 or more and 11 or less aromatic and heteroaromatic rings in total, especially may not comprise more than 11 aromatic and heteroaromatic rings in total,

The compound of formula (II) may comprise 1 or more and 3 or less heteroaromatic rings in total, especially may not comprise more than 3 aromatic and heteroaromatic rings in total. The compound of formula (II) may comprise 1 or 2 heteroaromatic rings in total, especially may not comprise more than 2 heteroaromatic rings in total.

The compound of formula (II) may have a molecular weight of 600 g/mol or more and 1,200 g/mol or less, of 600 g/mol or more and 1,000 g/mol or less, or of 600 g/mol or more and 900 g/mol or less, such as from about 640 g/mol to 880 g/mol.

It may be provided that the compound of formula (II) does not comprise a triaryl-amine moiety and does not comprise a carbazole-moiety.

The compound of formula (II) may have a triplet T1 level of 1.5 eV or more, such as of 1.5 eV or more and 3.0 eV or less.

The compound of formula (II) may have a LUMO energy level of -2.0 eV or more and -1.6 eV or less, of -1.9 eV or

more and -1.7 eV or less, or of -1.85 eV or more and -1.7 eV or less.

The compound of formula (II) may have a HOMO energy level of -5.90 eV or more and -5.10 eV or less, such as from -5.85 eV or more and -5.60 eV or less

The compound of formula (II) may have a band gap of 3.20 eV or more and 4.10 eV or less, or 3.29 eV or more and 4.07 eV or less, such as 3.73 eV or more and 4.07 eV or less.

The compound of formula (II) may have a dipole moment of o or more and 2 D or less, such as of 1.8 D or more and 1.21 D or less.

The compound of formula (II) may have a glass transition temperature (Tg) of 90 °C or more and 160°C or less, such as of 98 °C or more and 150°C or less.

The compound of formula (II) may be selected from E-2 to E-10

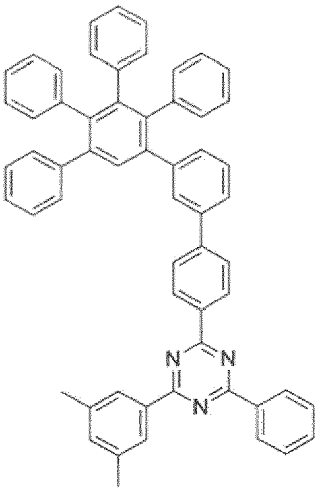
E-2

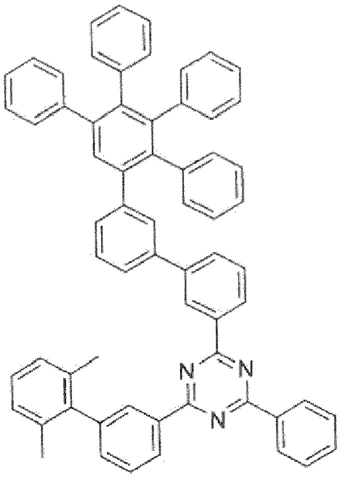
E-3

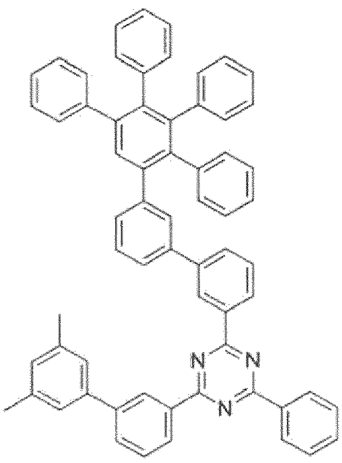
E-4

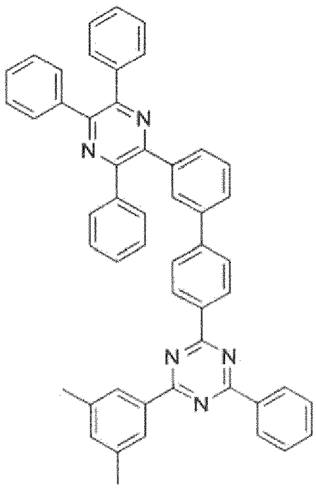
E-5

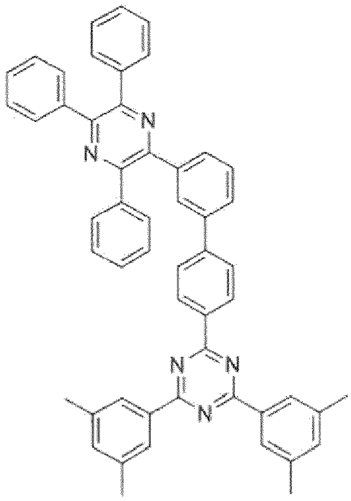
E-6

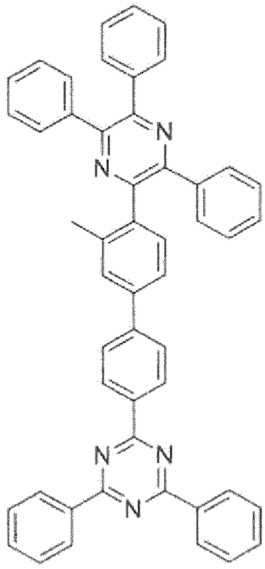
E-7

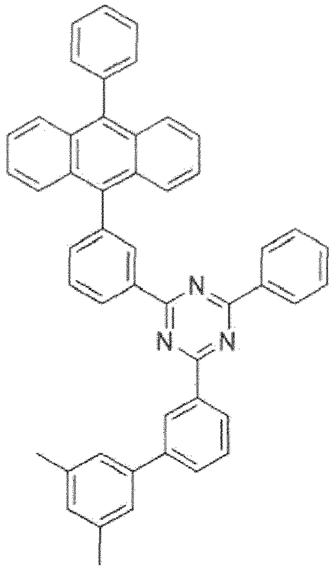
E-8

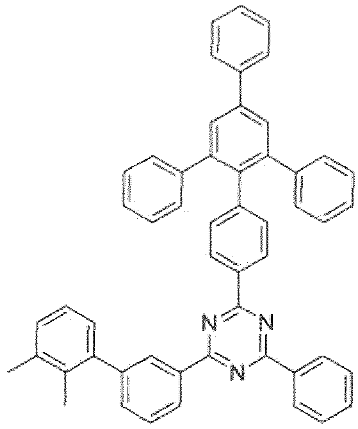
E-9

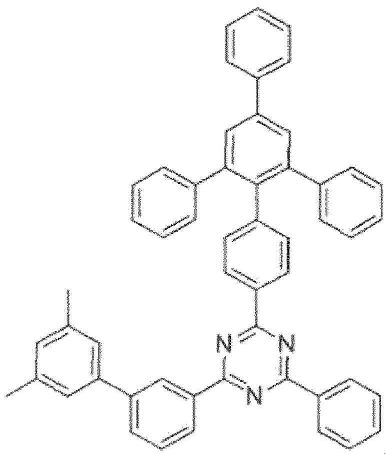
E-10.

GENERAL DEFINITIONS

If not explicitly mentioned else, each moiety of the compounds described herein, especially the compounds of formulas (1) and (II) may be substituted with one or more D (deuterium).

In the present specification, when a definition is not otherwise provided, an "alkyl group" may refer to an aliphatic hydrocarbon group. The alkyl group may refer to "a saturated alkyl group" without any double bond or triple bond. The term "alkyl" as used herein shall encompass linear as well as branched and cyclic alkyl. For example, $C_3$-alkyl may be selected from n-propyl and iso-propyl. Likewise, $C_4$-alkyl encompasses n-butyl, sec-butyl and t-butyl. Likewise, $C_6$-alkyl encompasses n-hexyl and cyclo-hexyl.

As used herein if not explicitly mentioned else, the asterisk symbol "*" represents a binding position at which the moiety labelled accordingly is bond to another moiety.

The term "aryl" or "arylene" as used herein shall encompass phenyl ($C_6$-aryl), fused aromatics, such as naphthalene, anthracene, phenanthrene, tetracene etc.. Further encompassed are biphenyl and oligo- or polyphenyls, such as terphenyl, phenyl-substituted biphenyl, phenyl-substituted terphenyl (such as tetraphenyl benzene groups) etc.. "Arylene" respectively "heteroarylene", refers to groups to which two further moieties are attached. In the present specification, the term "aryl group" or "arylene group" may refer to a group comprising at least one hydrocarbon aromatic moiety, and all the elements of the hydrocarbon aromatic moiety may have p-orbitals which form conjugation, for example a phenyl group, a napthyl group, an anthracenyl group, a phenanthrenyl group, a pyrenyl group, a fluorenyl group and the like. Further encompoassed are spiro compounds in which two aromatic moieties are connected with each other via a spiro-atom, such as 9,9'-spirobi[9H-fluorene]yl. The aryl or arylene group may include a monocyclic or fused ring polycyclic (i.e., links sharing adjacent pairs of carbon atoms) functional group.

The term "heteroaryl" as used herein refers to aryl groups in which at least one carbon atom is substituted with a heteroatom. The term "heteroaryl" may refer to aromatic heterocycles with at least one heteroatom, and all the elements of the hydrocarbon heteroaromatic moiety may have p-orbitals which form conjugation. The heteroatom may be selected from N, O, S, B, Si, P, Se, preferably from N, 4 and S. A heteroarylene ring may comprise at least 1 to 3 heteroatoms. Preferably, a heteroarylene ring may comprise at least 1 to 3 heteroatoms individually selected from N, S and/or O. Just as in case of "aryl"/"arylene", the term "heteroaryl" comprises, for example, spiro compounds in which two aromatic moieties are connected with each other, such as spiro[fluorene-9,9'-xanthene]. Further exemplary heteroaryl groups are diazine, triazine, dibenzofurane, dibenzothiofurane, acridine, benzoacridine, dibenzoacridine etc.

The term "alkenyl" as used herein refers to a group $-CR^1 = CR^2R^3$ comprising a carbon-carbon double bond.

The term "perhalogenated" as used herein refers to a hydrocarbyl group wherein all of the hydrogen atoms of the hydrocarbyl group are replaced by halogen (F, Cl, Br, I) atoms.

The term "alkoxy" as used herein refers to a structural fragment of the Formula -OR with R being hydrocarbyl, preferably alkyl or cycloalkyl.

The term "thioalkyl" as used herein refers to a structural fragment of the Formula -SR with R being hydrocarbyl, preferably alkyl or cycloalkyl.

The subscripted number n in $C_n$-heteroaryl merely refers to the number of carbon atoms excluding the number of heteroatoms. In this context, it is clear that a $C_3$ heteroarylene group is an aromatic compound comprising three carbon atoms, such as pyrazol, imidazole, oxazole, thiazole and the like.

The term "heteroaryl" as used herewith shall encompass pyridine, quinoline, benzoquinoline, quinazoline, benzoquinazoline, pyrimidine, pyrazine, triazine, benzimidazole, benzothiazole, benzo[4,5]thieno[3,2-d]pyrimidine, carbazole, xanthene, phenoxazine, benzoacridine, dibenzoacridine and the like.

In the present specification, the term single bond refers to a direct bond.

The term "fluorinated" as used herein refers to a hydrocarbon group in which at least one of the hydrogen atoms comprised in the hydrocarbon group is substituted by a fluorine atom. Fluorinated groups in which all of the hydrogen atoms thereof are substituted by fluorine atoms are referred to as perfluorinated groups and are particularly addressed by the term "fluorinated".

In terms of the invention, a group is "substituted with" another group if one of the hydrogen atoms comprised in this group is replaced by another group, wherein the other group is the substituent.

In accordance with the present disclosure, as an illustrative example using an arbitrary group A in a formula showing the following binding situation,

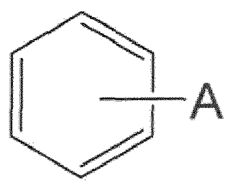

the group A may be bound to any suitable binding position. In a situation where it is shown that the bond of A crosses more than one ring

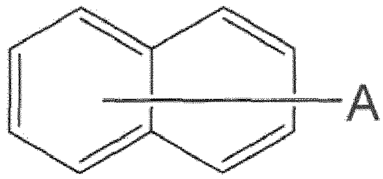

the group A may be bound to any suitable binding position of each ring crossed with the bond.

In terms of the invention, the expression "between" with respect to one layer being between two other layers does not exclude the presence of further layers which may be arranged between the one layer and one of the two other layers. In terms of the invention, the expression "in direct contact" with respect to two layers being in direct contact with each other means that no further layer is arranged between those two layers. One layer deposited on the top of another layer is deemed to be in direct contact with this layer.

The term "contacting sandwiched" refers to an arrangement of three layers whereby the layer in the middle is in direct contact with the two adjacent layers.

With respect to the inventive hole transport layer the compounds mentioned in the experimental part are most preferred.

A lighting device may be any of the devices used for illumination, irradiation, signaling, or projection. They are correspondingly classified as illuminating, irradiating, signaling, and projecting devices. A lighting device usually consists of a source of optical radiation, a device that transmits the radiant flux into space in the desired direction, and a housing that joins the parts into a single device and protects the radiation source and light-transmitting system against damage and the effects of the surroundings.

According to another aspect, the organic electroluminescent device according to the present invention comprises two or three or more emission layers. An OLED comprising more than one emission layer is also described as a tandem OLED or stacked OLED.

The organic electroluminescent device (OLED) may be a bottom- or top-emission device. The organic electroluminescent device (OLED) may emit the light through a transparent anode or through a transparent cathode.

Another aspect is directed to a device comprising at least one organic electroluminescent device (OLED).

A device comprising organic light-emitting diodes is for example a display or a lighting panel.

In the present invention, the following defined terms, these definitions shall be applied, unless a different definition is given in the claims or elsewhere in this specification.

In the context of the present specification the term "different" or "differs" in connection with the matrix material means that the matrix material differs in their structural Formula.

The terms "OLED" and "organic light-emitting diode" are used simultaneously and have the same meaning. The term "organic electroluminescent device" as used herein may comprise both organic light emitting diodes as well as organic light-emitting transistors (OLETs).

As used herein, "weight percent", "wt.-%", "percent by weight", "% by weight", and variations thereof refer to a composition, component, substance or agent as the weight of that component, substance or agent of the respective electron transport layer divided by the total weight of the respective electron transport layer thereof and multiplied by 100. It is under-stood that the total weight percent amount of all components, substances and agents of the respective electron transport layer and electron injection layer are selected such that it does not exceed 100 wt.-%.

As used herein, "volume percent", "vol.-%", "percent by volume", "% by volume", and variations thereof refer to a composition, component, substance or agent as the volume of that component, substance or agent of the respective electron transport layer divided by the total volume of the respective electron transport layer thereof and multiplied by 100. It is understood that the total volume percent amount of all components, substances and agents of the cathode layer are selected such that it does not exceed 100 vol.-%.

All numeric values are herein assumed to be modified by the term "about", whether or not explicitly indicated. As used herein, the term "about" refers to variation in the numerical quantity that can occur. Whether or not modified by the term "about" the claims include equivalents to the quantities.

It should be noted that, as used in this specification and the appended claims, the singular forms "a", "an", and "the" include plural referents unless the content clearly dictates otherwise.

The term "free of", "does not contain", "does not comprise" does not exclude impurities. Impurities have no technical effect with respect to the object achieved by the present invention.

In the context of the present specification the term "essentially non-emissive" or "non-emissive" means that the contribution of the compound or layer to the visible emission spectrum from the device is less than 10 %, preferably less

than 5 % relative to the visible emission spectrum. The visible emission spectrum is an emission spectrum with a wavelength of about ≥ 380 nm to about ≤ 780 nm.

Preferably, the hole blocking layer comprising the compound of Formula (I) is essentially non-emissive or non-emitting.

The operating voltage, also named U, is measured in Volt (V) at 10 milliampere per square centimeter ($mA/cm^2$).

The candela per ampere efficiency, also named cd/A efficiency or $C_{eff}$, is measured in candela per ampere at 10 milliampere per square centimeter ($mA/cm^2$).

The external quantum efficiency, also named EQE, is measured in percent (%).

The color space is described by coordinates CIE-x and CIE-y (International Commission on Illumination 1931). For blue emission the CIE-y is of particular importance. A smaller CIE-y denotes a deeper blue color. Efficiency values are compared at the same CIE-y.

The highest occupied molecular orbital, also named HOMO, and lowest unoccupied molecular orbital, also named LUMO, are measured in electron volt (eV).

The term "OLED", "organic light emitting diode", "organic light emitting device", "organic optoelectronic device" and "organic light-emitting diode" are simultaneously used and have the same meaning.

The term "life-span" and "lifetime" are simultaneously used and have the same meaning.

The anode and cathode may be described as anode electrode / cathode electrode or anode electrode / cathode electrode or anode electrode layer / cathode electrode layer.

Room temperature, also named ambient temperature, is 23° C.

Hereinafter, the embodiments are illustrated in more detail with reference to examples. However, the present disclosure is not limited to the following examples. Reference will now be made in detail to the exemplary aspects.

DESCRIPTION OF THE FIGURES

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object of the invention are disclosed in the dependent claims and the following description of the respective figures, which in an exemplary fashion show preferred embodiments according to the invention. Any embodiment does not necessarily represent the full scope of the invention, however, and reference is made therefore to the claims and herein for interpreting the scope of the invention. It is to be understood that both the foregoing general description and the following detailed description are exemplary and explanatory only and are intended to provide further explanation of the present invention as claimed.

FIG. 1 is a schematic sectional view of an OLED, according to an exemplary embodiment of the present invention.

FIG. 2 is a schematic sectional view of an OLED comprising a charge generation layer and two emission layers, according to an exemplary embodiment of the present invention.

Hereinafter, the figures are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic light-emitting diode (OLED) 100, according to an exemplary embodiment of the present invention. The OLED 100 includes a substrate 110, an anode 120, a hole injection layer (HIL) 130, a hole transport layer (HTL) 140, an electron blocking layer (EBL) 145, an emission layer (EML) 150, a hole blocking layer (HBL) 155, and an electron transport layer (ETL) 160. The electron transport layer (ETL) 160 is formed on the HBL 155. The HBL 155 comprises the compound of formula (1). Onto the electron transport layer (ETL) 160, an electron injection layer (EIL) 180 is disposed. The cathode 190 is disposed directly onto the electron injection layer (EIL) 180.

Fig. 2 is a schematic sectional view of an OLED 100, according to another exemplary embodiment of the present invention. Fig. 2 differs from Fig. 1 in that the OLED 100 of Fig. 2 further comprises a charge generation layer (CGL) and a second emission layer (151).

Referring to Fig. 2, the OLED 100 includes a substrate 110, an anode 120, a first hole injection layer (HIL) 130, a first hole transport layer (HTL) 140, a first electron blocking layer (EBL) 145, a first emission layer (EML) 150, a first hole blocking layer (HBL) 155, a first electron transport layer (ETL) 160, an n-type charge generation layer (n-type CGL) 185, a

hole generating layer (p-type charge generation layer; p-type GCL) 135, a second hole transport layer (HTL) 141, a second electron blocking layer (EBL) 146, a second emission layer (EML) 151, a second hole blocking layer (HBL) 156 which is the hole blocking layer comprising the compound of formula (I), a second electron transport layer (ETL) 161 and an alkali metal complex, a second electron injection layer (EIL) 181 and a cathode 190.

While not shown in Fig. 1 and Fig. 2 a sealing layer may further be formed on the cathode electrodes 190, in order to seal the OLEDs 100. In addition, various other modifications may be applied thereto.

Hereinafter, the embodiments are illustrated in more detail with reference to examples. However, the present disclosure is not limited to the following examples.

## EXPERIMENTAL PART

### Melting point

The melting point (mp) is determined as peak temperatures from the DSC curves of the above TGA-DSC measurement or from separate DSC measurements (Mettler Toledo DSC822e, heating of samples from room temperature to completeness of melting with heating rate 10 K/min under a stream of pure nitrogen. Sample amounts of 4 to 6 mg are placed in a 40 μL Mettler Toledo aluminum pan with lid, a <1 mm hole is pierced into the lid).

### Glass transition temperature

The glass transition temperature (Tg) is measured under nitrogen and using a heating rate of 10 K per min in a Mettler Toledo DSC 822e differential scanning calorimeter as described in DIN EN ISO 11357, published in March 2010.

### Rate onset temperature

The rate onset temperature ($T_{RO}$) is determined by loading 100 mg compound into a VTE source. As VTE source a point source for organic materials may be used as supplied by Kurt J. Lesker Company (www.lesker.com) or CreaPhys GmbH (http://www.creaphys.com). The VTE source is heated at a constant rate of 15 K/min at a pressure of less than 10-5 mbar and the temperature inside the source measured with a thermocouple. Evaporation of the compound is detected with a QCM detector which detects deposition of the compound on the quartz crystal of the detector. The deposition rate on the quartz crystal is measured in Angstrom per second. To determine the rate onset temperature, the deposition rate is plotted against the VTE source temperature. The rate onset is the temperature at which noticeable deposition on the QCM detector occurs. For accurate results, the VTE source is heated and cooled three time and only results from the second and third run are used to determine the rate onset temperature.

To achieve good control over the evaporation rate of an organic compound, the rate onset temperature may be in the range of 200 to 255 °C. If the rate onset temperature is below 200 °C the evaporation may be too rapid and therefore difficult to control. If the rate onset temperature is above 255 °C the evaporation rate may be too low which may result in low tact time and decomposition of the organic compound in VTE source may occur due to prolonged exposure to elevated temperatures.

The rate onset temperature is an indirect measure of the volatility of a compound. The higher the rate onset temperature the lower is the volatility of a compound.

### Reduction potential

The reduction potential is determined by cyclic voltammetry with potenioststic device Metrohm PGSTAT30 and software Metrohm Autolab GPES at room temperature. The redox potentials given at particular compounds were measured in an argon de-aerated, dry 0.1M THF solution of the tested substance, under argon atmosphere, with 0.1M tetrabutylammonium hexafluorophosphate supporting electrolyte, between platinum working electrodes and with an Ag/AgCl pseudo-standard electrode (Metrohm Silver rod electrode), consisting of a silver wire covered by silver chloride and immersed directly in the measured solution, with the scan rate 100 mV/s. The first run was done in the broadest range of the potential set on the working electrodes, and the range was then adjusted within subsequent runs appropriately. The final three runs were done with the addition of ferrocene (in 0.1M concentration) as the standard. The average of potentials corresponding to cathodic and anodic peak of the studied compound, after subtraction of the average of cathodic and anodic potentials observed for the standard Fc+/Fc redox couple, afforded finally the values reported above. All studied compounds as well as the reported comparative compounds showed well-defined reversible electrochemical behaviour.

Dipole moment

The dipole moment $|\vec{\mu}|$ of a molecule containing N atoms is given by:

$$\vec{\mu} = \sum_{i}^{N} q_i \vec{r_i}$$

$$|\vec{\mu}| = \sqrt{\mu_x^2 + \mu_y^2 + \mu_z^2}$$

where $q_i$ and $\vec{r_i}$ are the partial charge and position of atom i in the molecule.

The dipole moment is determined by a semi-empirical molecular orbital method.

The geometries of the molecular structures are optimized using the hybrid functional B3LYP with the 6-31G* basis set in the gas phase as implemented in the program package TURBOMOLE V6.5 (TURBO MOLE GmbH, Litzenhardtstrasse 19, 76135 Karlsruhe, Germany). If more than one conformation is viable, the conformation with the lowest total energy is selected to determine the bond lengths of the molecules.

Calculated HOMO, LUMO, T1 triplet level

The HOMO, LUMO and T1 triplet are calculated with the program package TURBOMOLE V6.5 (TURBOMOLE GmbH, Litzenhardtstrasse 19, 76135 Karlsruhe, Germany). The optimized geometries and the HOMO, LUMO and T1 triplet energy levels of the molecular structures are determined by applying the hybrid functional B3LYP with a 6-31G* basis set in the gas phase. If more than one conformation is viable, the conformation with the lowest total energy is selected.

Synthesis Procedures

**(E-1)- 2-(3,5-dimethyl-4"-phenyl-[1,1':3',1":3",1‴-quaterphenyl]-5'-yl)-4,6-diphenyl-1,3,5-triazine**

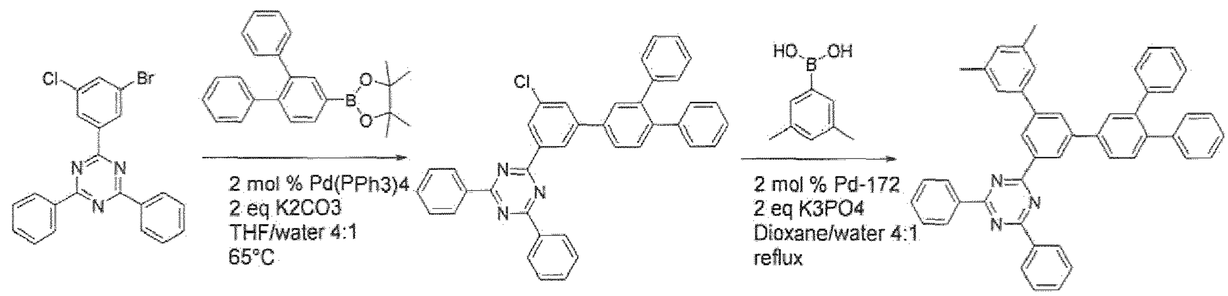


**1st Step. 2-(4-chlorophenyl)-3-(dibenzo[b,d]furan-3-yl)-5,6-diphenylpyrazine**

3 Neck round-bottom flask was flushed with nitrogen and charged with 2-(3-bromo-5-chlorophenyl)-4,6-diphenyl-1,3,5-triazine (CAS 1073062-42-6) 1 eq (100,0 g), 2-([1,1':2',1"-terphenyl]-4'-yl)-4,4,5,5-tetramethyl-1,3,2-dioxaborolane (CAS 2144472-52-4) 1 eq (92,7 g), tetrakis(triphenylphosphine)palladium(o) (CAS 14221-01-3) 0,02 eq (5,5 g), potassium carbonate (CAS 584-08-7) 2 eq (65,4 g). Deaerated mixture of 1 L THF and 250 ml water was added. Reaction was running at 65°C under a nitrogen atmosphere overnight. After cooling down to room temperature beige suspension was formed. Raw solid material was filtered, washed with water and methanol and dried at low pressure. Product was dissolved at elevated temperature in 1,5 L chloroform and filtered hot through a silica pad. After solvent evaporation the product obtained as a white powder. Yield: 101,0 g (75 %). (LC-MS: 572,1) .

**2nd Step. 2-(3,5-dimethyl-4"-phenyl-[1,1':3',1":3",1‴-quaterphenyl]-5'-yl)-4,6-diphenyl-1,3,5-triazine**

3 Neck round-bottom flask was flushed with nitrogen and charged with 2-(5-chloro-4'-phenyl-[1,1':3',1"-terphenyl]-3-yl)-4,6-diphenyl-1,3,5-triazine (no CAS) 1 eq (10,0 g), 3,5-dimethylphenylboronic acid (CAS 172975-69-8) 1,1 eq (2,9 g), chloro(crotyl)(2-dicyclohexylphosphino-2',6'-dimethoxybiphenyl) palladium(II) (CAS 1798781-99-3) 0,02 eq (0,2 g), potassium phosphate (CAS 7778-53-2) 2 eq (7,4 g). Deaerated mixture of 80 ml dioxane and 20 ml water was added. Reaction was running at reflux under a nitrogen atmosphere overnight. Thick suspension was formed. Reaction mixture was cooled down, filtered, raw solid material was washed with dioxane, water and methanol. Then the product was dissolved in 400 ml chloroform, dried over $MgSO_4$ and filtered through a silica pad. Final purification was done by sublimation. White powder. Yield: 7,8 g (71 %). (LC-MS: 642,2).

**(E-2) - 2-(3,5-dimethylphenyl)-4-phenyl-6-(4',5',6'-triphenyl-[1,1':2',1":3",1‴-quaterphenyl]-4‴-yl)-1,3,5-triazine**

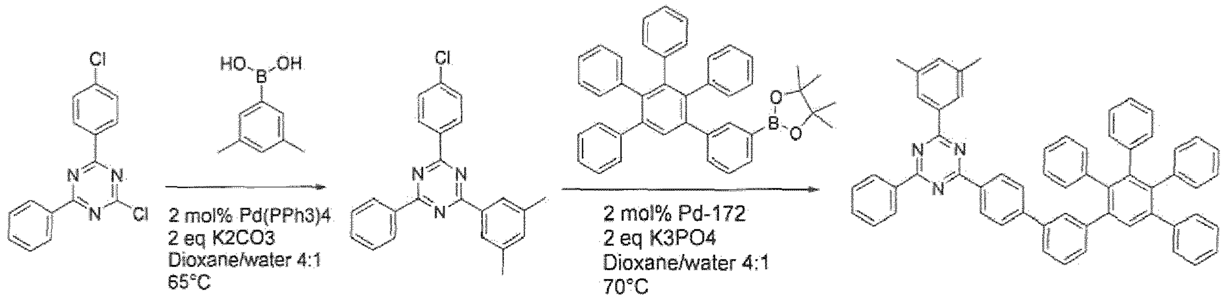


**1st Step. 2-(4-chlorophenyl)-4-(3,5-dimethylphenyl)-6-phenyl-1,3,5-triazine**

3 Neck round-bottom flask was flushed with nitrogen and charged with 2-chloro-4-(4-chlorophenyl)-6-phenyl-1,3,5-triazine (CAS 30894-93-0) 1 eq (30,0 g), 3,5-dimethylphenylboronic acid (CAS 172975-69-8) 1,1 eq (16,4 g), tetrakis(triphenylphosphine)palladium(o) (CAS 14221-01-3) 0,02 eq (2,3 g), potassium carbonate (CAS 584-08-7) 2 eq (27,4 g). Deaerated mixture of 400 ml dioxane and 100 ml water was added. Reaction was running at 65°C under a nitrogen atmosphere overnight. After cooling down to room temperature yellow suspension was formed. Raw solid material was filtered, washed with dioxane, acetone, water and methanol and dried at low pressure. Product was dissolved in 1 L DCM and filtered through a silica pad. After solvent evaporation the product obtained as a white powder. Yield: 28,9 g (78 %). (LC-MS: 372,1).

**2nd Step. 2-(3,5-dimethylphenyl)-4-phenyl-6-(4',5',6'-triphenyl-[1,1':2',1":3",1‴-quaterphenyl]-4‴-yl)-1,3,5-triazine**

3 Neck round-bottom flask was flushed with nitrogen and charged with 2-(4-chlorophenyl)-4-(3,5-dimethylphenyl)-6-phenyl-1,3,5-triazine (no CAS) 1,0 eq (12,4 g), 4,4,5,5-tetramethyl-2-(3',4',5'-triphenyl-[1,1':2',1"-terphenyl]-3-yl)-1,3,2-dioxaborolane (CAS 872118-08-6) 1,05 eq. (20,5 g), chloro(crotyl)(2-dicyclohexylphosphino-2',6'-dimethoxybiphenyl) palladium(II) (CAS 1798781-99-3) 0,02 eq. (0,4 g), potassium phosphate (CAS 7778-53-2) 2,0 eq. (14,1 g). Deaerated mixture of 120 ml dioxane and 30 ml water was added. Reaction was running at 70°C under a nitrogen atmosphere for 2 hours. After cooling down to room temperature thick grey suspension was formed, raw solid material was filtered and washed with dioxane, water and methanol. Then the product was dissolved in 850 ml chloroform and filtered through a silica pad. Solvent was removed under reduced pressure and solid was stirred in a mixture of hexane and methanol (5%). After filtration it was dried under vacuum. Final purification was done by sublimation. White powder. Yield: 26,2 g (99 %). (LC-MS: 794,3).

**(E-3)- 2-(2',6'-dimethyl-[1,1'-biphenyl]-3-yl)-4-phenyl-6-(4',5',6'-triphenyl-[1,1':2',1":3",1‴-quaterphenyl]-3‴-yl)-1,3,5-triazine**

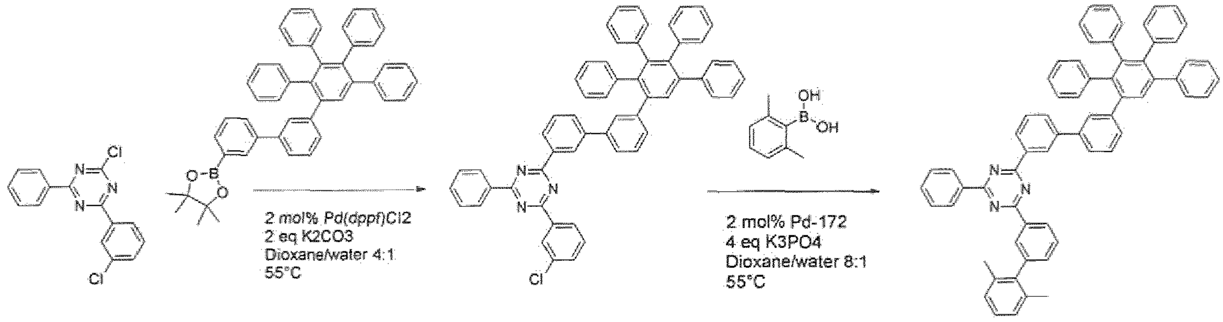


**1st Step. 2-(3-chlorophenyl)-4-phenyl-6-(4',5',6'-triphenyl-[1,1':2',1":3",1'''-quaterphenyl]-3'''-yl)-1,3,5-triazine**

3 Neck round-bottom flask was flushed with nitrogen and charged with 2-chloro-4-(3-chlorophenyl)-6-phenyl-1,3,5-triazine (CAS 2125473-29-0) 1,05 eq (8,3 g), 4,4,5,5-tetramethyl-2-(4',5',6'-triphenyl-[1,1':2',1":3",1'''-quaterphenyl]-3'''yl)-1,3,2-dioxaborolane (CAS 2032365-26-5) 1,0 eq (17,3 g), [1,1'-bis(diphenylphosphino)ferrocene]dichloropalladium(II) (CAS 72287-26-4) 0,02 eq (0,4 g), potassium carbonate (CAS 584-08-7) 2 eq (7,2 g). Deaerated mixture of 200 ml dioxane and 50 ml water was added. Reaction was running at 55°C under a nitrogen atmosphere overnight. After cooling down to room temperature orange suspension was formed. Raw solid material was filtered, washed with dioxane, water, methanol and hexane and dried at low pressure. Product was dissolved in 500 ml DCM and filtered through a silica pad. Solvent was evaporated and solid was stirred in a mixture of 100 ml chloroform and 150 ml methanol. After filtration and drying the product obtained as a white powder. Yield: 15,6 g (75 %). (LC-MS: 800,2).

**2nd Step. 2-(2',6'-dimethyl-[1,1'-biphenyl]-3-yl)-4-phenyl-6-(4',5',6'-triphenyl-[1,1':2',1":3",1'''-quaterphenyl]-3'''-yl)-1,3,5-triazine**

3 Neck round-bottom flask was flushed with nitrogen and charged with 2-(3-chlorophenyl)-4-phenyl-6-(4',5',6'-triphenyl-[1,1':2',1":3",1'''-quaterphenyl]-3'''-yl)-1,3,5-triazine (no CAS) 1,0 eq (5,5 g), 2,6-dimethylphenylboronic acid (CAS 100379-00-8) 2,5 eq. (2,7 g), chloro(crotyl)(2-dicyclohexylphosphino-2',6'-dimethoxybiphenyl) palladium(II) (CAS 1798781-99-3) 0,02 eq. (0,1 g), potassium phosphate (CAS 7778-53-2) 4,0 eq. (3,8 g). Deaerated mixture of 100 ml dioxane and 13 ml water was added. Reaction was running at 55°C under a nitrogen atmosphere for 3 days. After cooling down to room temperature grey suspension was formed, raw solid material was filtered and washed with dioxane, water and methanol. Then the product was dissolved in 300 ml chloroform and filtered through a silica pad. Solvent was removed under reduced pressure and the solid was stirred in a mixture of 20 ml chloroform and 80 ml hexane. After filtration, it was dried under vacuum and final purification was done by sublimation. White powder. Yield: 4,5 g (75 %). (LC-MS: 870,4).

**(E-4) - 2-(3',5'-dimethyl-(1,1'-biphenyl]-3-yl)-4-phenyl-6-(4',5',6'-triphenyl-[1,1':2',1":3",1'''-quaterphenyl]-3'''-yl)-:1,3,5-triazine**

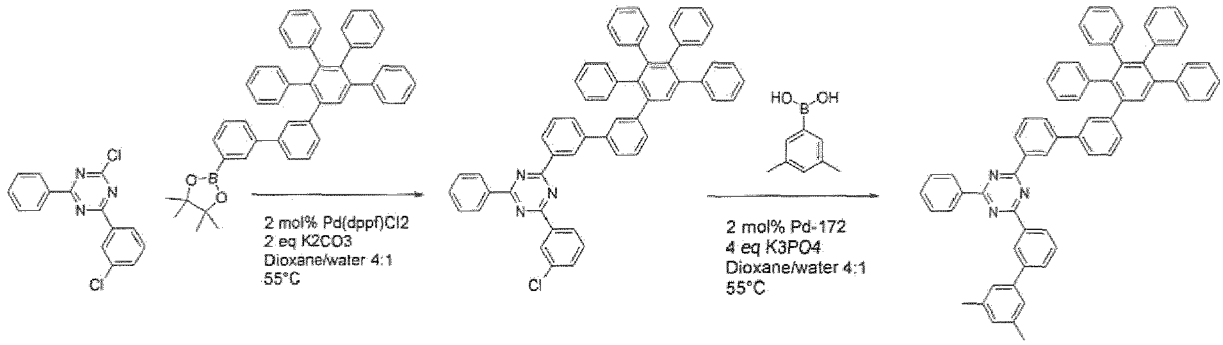


**1st Step. 2-(3-chlorophenyl)-4-phenyl-6-(4',5',6'-triphenyl-[1,1':2',1":3",1'''-quaterphenyl]-3'''-yl)-1,3,5-triazine**

3 Neck round-bottom flask was flushed with nitrogen and charged with 2-chloro-4-(3-chlorophenyl)-6-phenyl-1,3,5-triazine (CAS 2125473-29-0) 1,05 eq (8,3 g), 4,4,5,5-tetramethyl-2-(4',5',6'-triphenyl-[1'1':2',1":3",1'''-quaterphenyl]-3‴-yl)-1,3,2-dioxaborolane (CAS 2032365-26-5) 1,0 eq (17,3 g), [1,1'-bis(diphenylphosphino)ferrocene]dichloropalladium(II) (CAS 72287-26-4) 0,02 eq (0,4 g), potassium carbonate (CAS 584-08-7) 2 eq (7,2 g). Deaerated mixture of 200 ml dioxane and 50 ml water was added. Reaction was running at 55°C under a nitrogen atmosphere overnight. After cooling down to room temperature orange suspension was formed. Raw solid material was filtered, washed with dioxane, water, methanol and hexane and dried at low pressure. Product was dissolved in 500 ml DCM and filtered through a silica pad. Solvent was evaporated and solid was stirred in a mixture of 100 ml chloroform and 150 ml methanol. After filtration and drying the product obtained as a white powder. Yield: 15,6 g (75 %). (LC-MS: 800,2).

**2nd Step. 2-(3',5'-dimethyl-[1,1'-biphenyl]-3-yl)-4-phenyl-6-(4',5',6'-triphenyl-[1,1':2',1":3",1‴-quaterphenyl]-3‴-yl)-1,3,5-triazine**

3 Neck round-bottom flask was flushed with nitrogen and charged with 2-(3-chlorophenyl)-4-phenyl-6-(4',5',6'-triphenyl-[1,1':2',1":3",1‴-quaterphenyl]-3‴-yl)-1,3,5-triazine (no CAS) 1,0 eq. (8,6 g), (3,5-dimethylphenyl)boronic acid (CAS 172975-69-8) 1,6 eq. (2,6 g), crotyl(2-dicyclohexylphosphino-2',6'-dimethoxybiphenyl)palladium(II) (CAS 1798781-99-3) 0,02 eq. (0,2 g), potassium phosphate (CAS 7778-53-2) 2,0 eq. (4,6 g). Deaerated mixture of 40 ml dioxane and 10 ml water was added. Reaction was running at 55°C under a nitrogen atmosphere overnight. After cooling down to room temperature solvents were removed under reduced pressure. Residue was dissolved in 150 ml DCM, washed with water, dried with $MgSO_4$ and filtered through a silica pad. Solution was slowly added over 300 ml methanol. Precipitate was filtered, dried under vacuum. Final purification was done by sublimation. White powder. Yield: 7,4 g (79 %). (LC-MS: 870,4).

**(E-10) - 2-(3',5'-dimethyl-[1,1'-biphenyl]-3-yl)-4-(2',6'-diphenyl-[1,1':4',1"-terphenyl]-4-yl)-6-phenyl-1,3,5-triazine**

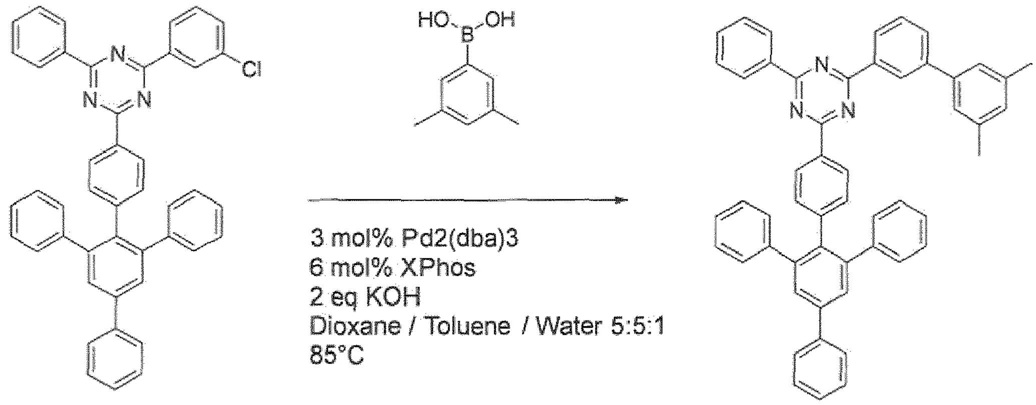


3 Neck round-bottom flask was flushed with nitrogen and charged with 3,5-dimethylphenylboronic acid (CAS 172975-69-8) 1,8 eq. (9,4 g), 2-(3-chlorophenyl)-4-(2',6'-diphenyl-[1,1':4',1"-terphenyl]-4-yl)-6-phenyl-1,3,5-triazine (CAS 2437303-47-2) 1,0 eq. (22,6 g), tris(dibenzylidenaceton)dipalladium(o) (CAS 51364-51-3) 0,03 eq (0,9 g), 2-dicyclohexylphosphino-2',4',6'-tri-isopropyl-1,1'-biphenyl (CAS 564483-18-7) 0,06 eq. (0,9 g), potassium hydroxide (CAS 1310-58-3) 2,0 eq. (3,9 g). Deaerated mixture of 175 ml dioxane, 175 ml toluene and 35 ml water was added. Reaction was running at 85°C under a nitrogen atmosphere overnight. After cooling down to room temperature solvents were removed under reduced pressure. Residue was dissolved in 500 ml DCM, washed with water, dried with $MgSO_4$ and filtered through a silica pad. Then solvent was partially removed and hexane was added. Precipitate was filtered, dried under vacuum and final purification was done by sublimation. Yield: 23,9 g (95 %). (LC-MS: 718,3).

**(E-7) - 2-(3'-methyl-4'-(3,5,6-triphenylpyrazin-2-yl)-[1,1'-biphenyl]-4-yl)-4,6-diphenyl-1,3,5-triazine**

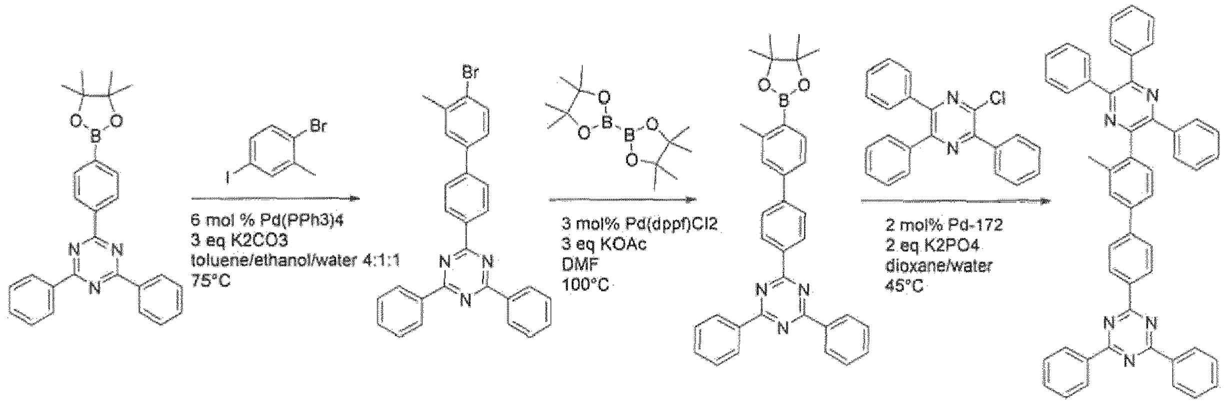


**1st Step. 2-(4'-bromo-3'-rnethyl-[1,1'-biphenyl]-4-yl)-4,6-diphenyl-1,3,5-triazine**

3 Neck round-bottom flask was flushed with nitrogen and charged with 2,4-diphenyl-6-(4-(4,4,5,5-tetramethyl-1,3,2-dioxaborolan-2-yl)phenyl)-1,3,5-triazine (CAS 1219956-23-6) 1 eq (30,0 g), 1-bromo-4-iodo-2-methylbenzene (CAS 202865-85-8) 2,8 eq (45,0 g), tetrakis(triphenylphosphine)palladium(o) (CAS 14221-01-3) 0,06 eq (4,8 g), potassium carbonate (CAS 584-08-7) 3 eq (28,5 g), Deaerated mixture of 400 ml toluene, 100 ml ethanol and 100 ml water was added. Reaction was running at 75°C under inert atmosphere for 2 days. Then the flask was cooled down and solvents were evaporated. Raw product was extracted in chloroform, washed with water, dried over $MgSO_4$. and filtered through a silica pad. Then solvent was evaporated. Obtained solid was macerated in toluene at room temperature for 2 hours, then filtered and dried. White powder. Yield: 11,1 g (80%). (LC-MS: 478,1).

**2nd Step. 2-(3'-methyl-4'-(4,4,5,5-tetramethyl-1,3,2-dioxahorolan-2-yl)-[1,1'-biphenyl]-4-yl)-4,6-diphenyl-1,3,5-triazine**

3 Neck round-bottom flask was flushed with argon and charged with 2-(4'-bromo-3'-methyl-[1,1'-biphenyl]-4-yl)-4,6-diphenyl-1,3,5-triazine (no CAS) 1 eq (10,5 g), 4,4,4',4',5,5,5',5-octamethyl-2,2'-bi(1,3,2-dioxaborolane) (CAS 73183-34-3) 1,1 eq (5,6 g), [1,1'-bis(diphenylphosphino)ferrocene]dichloropalladium(II) (CAS 72287-26-4) 0,03 eq (0,5 g), potassium acetate (CAS 127-08-2) 3 eq (6,5 g). Deaerated mixture of 120 ml DMF was added. Reaction was running at 100°C under an argon atmosphere overnight. The next day reaction was cooled down and solvent was evaporated. Raw product was extracted in chloroform, washed with water, dried over $MgSO_4$, filtered through a silica pad. Then the solvent was evaporated affording white powder. Yield: 8,5 g (74%). (LC-MS: 526,2).

**3rd Step. 2-(3'-methyl-4'-(3,5,6-triphenylpyrazin-2-yl)-[1,1'-biphenyl]-4-yl)-4,6-diphenyl-1,3,5-triazine**

3 Neck round-bottom flask was flushed with nitrogen and charged with 2-(3'-methyl-4'-(4,4,5,5-tetramethyl-1,3,2-dioxaborolan-2-yl)-[1,1'-biphenyl]-4-yl)-4,6-diphenyl-1,3,5-triazine (no CAS) 1 eq (8,4 g), 2-chloro-3,5,6-triphenylpyrazine (CAS 243472-78-8 ) 1 eq (5,5 g), chloro(crotyl)(2-dicyclohexylphosphino-2',6'-dimethoxybiphenyl) palladium(II) (CAS 1798781-99-3) 0,02 eq (0,2 g), potassium phosphate (CAS 7778-53-2) 2 eq (6,8 g). Deaerated mixture of 100 ml dioxane and 20 ml water was added. Reaction was running at 45°C under a nitrogen atmosphere overnight. Next day the brown suspension was formed and the reaction was cooled down. Precipitate was filtrated and washed with water, methanol, dried at low pressure. Raw product was dissolved in 500 ml chloroform and filtrated through silica pad. Then the solvent was evaporated. Next the product was recrystallized from chlorobenzene. Final purification was done by sublimation. White powder. Yield: 4,3 g (37,6 %). (LC-MS: 706,3).

**(E-9) - 2-(2',3'-dimethyl-[1,1'-biphenyl]-3-yl)-4-(2',6'-diphenyl-[1,1':4',1"-terphenyl]-4-yl)-6-phenyl-1,3,5-triazine**

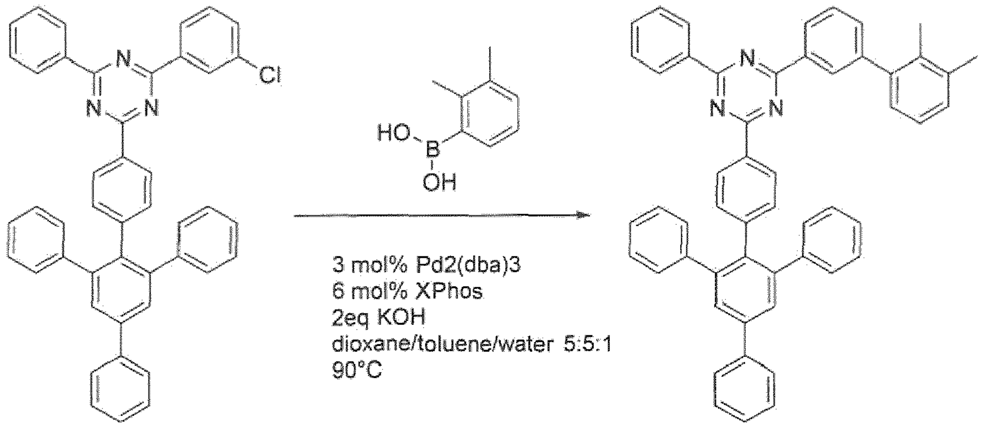


3 Neck round-bottom flask was flushed with nitrogen and charged with 2-(3-chlorophenyl)-4-(2',6'-diphenyl-[1,1':4',l"-terphenyl]-4-yl)-6-phenyl-1,3,5-triazine (CAS 2437303-47-2) 1 eq (22,6 g), (2,3-dimethylphenyl)boronic acid (CAS 183158-34-1) 1,8 eq (9,4 g), tris(dibenzylidenacetone)dipalladium(o) (CAS 51364-51-3) 0,03 eq (1,0 g), 2-dicyclohexylphosphino-2',4',6'-triisopropylbiphenyl (CAS 564483-18-7) 0,06 eq (1,0 g), potassium hydroxide (CAS 1310-58-3) 2 eq (3,9 g). Deaerated mixture of 175 ml dioxane, 175 ml toluene and 35 ml water was added. Reaction was running at 90°C under a nitrogen atmosphere overnight. After cooling down to room temperature brown solution was formed. Solvents were evaporated and the solid was extracted in DCM, washed with water, dried over $MgSO_4$ and filtered through a silicate pad. DCM was then partially evaporated and hexane added affording formation of white precipitate. Product was next filtrated, washed with hexane and methanol, dried. Final purification was done by sublimation. White powder. Yield: 24,2 g (94%). (ESI-MS: 718,3).

**(E-5) - 2-(3,5-dimethylphenyl)-4-phenyl-6-(3'-(3,5,6-triphenylpyrazin-2-yl)-[1,1'-biphenyl]-4-yl)-1,3,5-triazine**

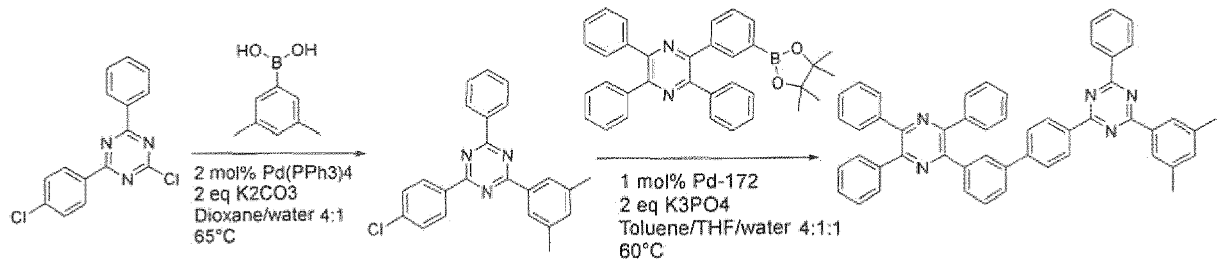


**1st Step. Synthesis of 2-(4-chlorophenyl)-4-(3,5-dimethylphenyl)-6-phenyl-1,3,5-triazine**

3 Neck round-bottom flask was flushed with nitrogen and charged with 2-chloro-4-(4-chlorophenyl)-6-phenyl-i1,3,5-triazine (CAS 30894-93-0) 1 eq (30 g), (3,5-dimethylphenyl)boronic acid (CAS 172975-69-8) 1,1 eq (16,4 g), tetrakis(triphenylphospliine)palladium(o) (CAS 14221-01-3) 0,02 eq (2,3 g), potassium carbonate (CAS 584-08-7) 2 eq (27,4 g). Deaerated mixture of 400 ml dioxane and 100 ml water was added. Reaction was running at 65°C under a nitrogen atmosphere overnight. After cooling down to room temperature grey suspension was formed. Raw solid material was filtered, washed with dioxane, acetone, water and methanol, and dried at low pressure. Product was dissolved in 1 L DCM and filtered through a silica pad. Solvent was evaporated and the product obtained as a white powder. Yield: 28,9 g (78%). (LC-MS: 373,1)

**2nd Step. Synthesis of 2-(3,5-dimethylphenyl)-4-phenyl-6-(3'-(3,5,6-triphenylpyrazin-2-yl)-[1,1'-biphenyl]-4-yl)-1,3,5-triazine**

3 Neck round-bottom flask was flushed with nitrogen and charged with 2-(4-chlorophenyl)-4-(3,5-dimethylphenyl)-6-phenyl-1,3,5-triazine (no CAS) 1,0 eq. (15 g), 2,3,5-triphenyl-6-(3-(4,4,5,5-tetramethyl-1,3,2-dioxaborolan-2-yl)phenyl)pyrazine (CAS 2396743-64-7) 0,95 eq. (19,6 g), crotyl(2-dicyclohexylphosphino-2',6'-dimethoxybiphenyl)palladium(II) (CAS 1798781-99-3) 0,01 eq. (0,13 g), potassium phosphate (CAS 7778-53-2) 2,0 eq. (17,1 g). Deaerated mixture of 160 ml toluene, 40 ml THF and 40 ml water was added. Reaction was running at 6o°C under a nitrogen

atmosphere for 3 days. After cooling down to room temperature grey suspension was formed. Raw solid material was filtered, washed with THF, water, methanol and hexane and dried at low pressure. Residue was dissolved in 2 L chlorobenzene and filtered hot through a silica pad. Solvent was evaporated and solid material was recrystallized from DMF. Final purification was done by sublimation. White powder. Yield: 17,9 g (62 %). (LC-MS: 721,3).

**(E-6) - 2,4-bis(3,5-dimethylphenyl)-6-(3'-(3,5,6-triphenylpyrazin-2-yl)-[1,1'-biphenyl]-4-yl)-1,3,5-triazine**

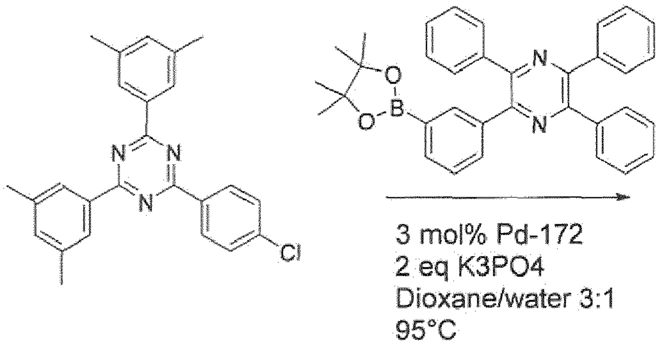


3 Neck round-bottom flask was charged with 2,3,5-triphenyl-6-(3-(4,4,5,5-tetramethyl-1,3,2-dioxaborolan-2-yl)phenyl)pyrazine (CAS 2396743-64-7) 1,0 eq. (17,8 g), 2-(4-chlorophenyl)-4,6-bis(3,5-dimethylphenyl)-1,3,5-triazine (CAS 2830402-45-2) 1,05 eq. (14,6 g), crotyl(2-dicyclohexylphosphino-2',6'-dimethoxybiphenyl)palladium(II) (CAS 1798781-99-3) 0,03 eq. ζo,G g), potassium phosphate (CAS 7778-53-2) 2,0 eq. (14,8 g). Flask was then evacuated and flushed with argon. Deaerated mixture of 240 ml dioxane and 80 ml water was added, and the reaction was running at 95°C under argon atmosphere overnight. Reaction mixture was let to cool to room temperature and thick grey suspension was formed. Solid material was filtered and washed with dioxane, DCM, water, methanol and finally mixture of DCM in methanol (5%). Solid was dried, adsorbed on silica gel (100 g) and chromatographed using DCM/petroleum ether (1:1) as eluent. Then solvent was removed under reduced pressure affording white powder. Final purification was done by sublimation. Yield: 21 g (82%). (LC-MS: 748,3).

**(E-8) - 2-(3',5'-dimethyl-[1,1'-biphenyl]-3-yl)-4-phenyl-6-(3-(10-phenylanthracen-9-yl)phenyl)-1,3,5-triazine**

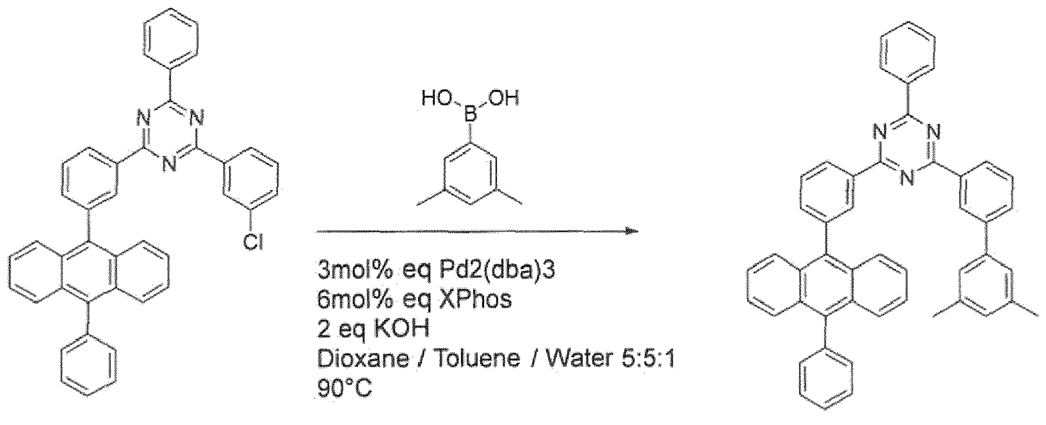


3 Neck round-bottom flask was charged with 2-(3-chlorophenyl)-4-phenyl-6-(3-(10-phenylanthracen-9-yl)phellyl)-1,3,5-triazine (CAS 2576432-81-8) 1,0 eq. (22,4 g), (3,5-dimethylphenyl)boronic acid (CAS 172975-69-8) 1,8 eq (10,1 g), tris(dibenzylidenaceton)dipalladium(o) (CAS 51364-51-3) 0,03 eq (1,0 g), 2-dicyclohexylphosphino-2',4',6'-tri-iso-propyl-1,1'-biphenyl (CAS 564483-18-7) 0,06 eq. (1,1 g), potassium hydroxide (CAS 1310-58-3) 2,0 eq. (4,2 g). Flask was then evacuated and flushed with nitrogene. Deaerated mixture of 200 ml dioxane, 200 ml toluene and 40 ml water was added, and the reaction was running at 90°C under inert atmosphere overnight. After cooling down to room temperature grey suspension was formed. Solid raw material was filtered, washed with dioxane, toluene, water and methanol. Then the material was dissolved in 400 ml DCM and filtered through a silica pad. Solvent was evaporated and solid material was

macerated first in acetonitrile and then in the mixture of 200 ml DCM with 400 ml hexane. Final purification was done by sublimation. Yield: 13,6 g (54%). (LC-MS: 666,3).

Table 1: Properties of the synthesized compounds

| Material | Thermal data | | | DFT data (B3LYP_Gaussian / 6-31G*, gas phase) | | | | |
|---|---|---|---|---|---|---|---|---|
| | Tg | Tm | Td5% * | HOMO [eV] | LUMO [eV] | Band gap [eV] | Dipole [D] | T1 [eV] |
| E-1 | 98 | 277 | 449 | -5.76 | -1,82 | 4,02 | 0,34 | 2,87 |
| E-2 | 150 | - | 477 | -5,80 | -1,80 | 4,00 | 0,71 | 2,82 |
| E-3 | 145 | 300 | 480 | -5,80 | -1,80 | 4,00 | 0,64 | 2,95 |
| E-4 | 136 | - | 494 | -5,83 | -1,76 | 4,07 | 1,21 | 2,94 |
| E-5 | 134 | 293 | 479 | -5,66 | -1,84 | 3,83 | 0,62 | 2,59 |
| E-6 | 137 | 269 | 482 | -5,77 | -1,79 | 3,98 | 0,18 | 2,75 |
| E-7 | 129 | 283 | 478 | -5,66 | -1,93 | 3,73 | 0,88 | 2,60 |
| E-8 | 130 | 277 | 461 | -5,11 | -1,82 | 3,29 | 0,38 | 1,73 |
| E-9 | 136 | 231 | 463 | -5,83 | -1,80 | 4,03 | 0,47 | 2,85 |
| E-10 | 135 | 259 | 468 | -5,81 | -1,81 | 4,00 | 0,63 | 2,82 |
| • Td5% = Temperature determined by TGA at 5% weight loss (10 K/min) | | | | | | | | |

Device experiments

*General procedure for fabrication of bottom-emission OLEDs*

For bottom emission OLED device, an ITO/glass substrate was cut to a size of 150 mm × 150 mm × 0.7 mm, rinse with isopropyl alcohol for ~5 minutes and then with ultrasonically cleaned pure water for~ 5 minutes, and baked out in oven at 200°C for ~2h. Before organic material deposition it gets plasma treatment in vacuum chamber (typically $N_2$ plasma).

The device was made by depositing a hole injection layer of HT-1 doped with D-1 onto substrate provided with ITO anode, followed by an undoped hole transport layer of HT-1. Subsequently, an electron blocking layer of HT-2 was deposited onto the HTL. Subsequently, a blue fluorescent emitting layer of emitter host HOST-1 doped with EMITTER-1 was deposited. On the emission layer, a layer made of the comparative compound or the inventive compounds was deposited as a hole blocking layer. An electron transport layer of ET-1 was co-deposited with LiQ onto the HBL. Subsequently, Al cathode was deposited. All depositions were made by vacuum thermal evaporation.

Stack: ITO, 90nm / (HT-1): (D-1) (2wt%), 10nm / (HT-1), 128nm / (HT-2), 5nm / H09 (HOST-1) :BD200 (EMITTER-1) (3vol%), 20nm / HBL (100 % inventive or comparative compound), 5nm / (ET-1):LiQ (sovol%), 31nm / Al, 100nm

Tested compounds:

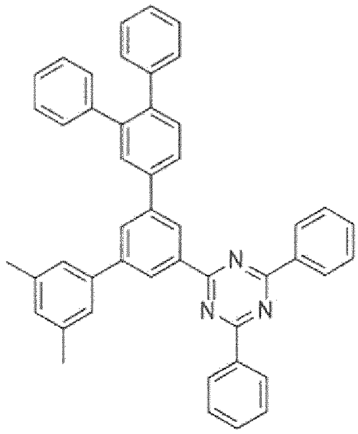

E-1

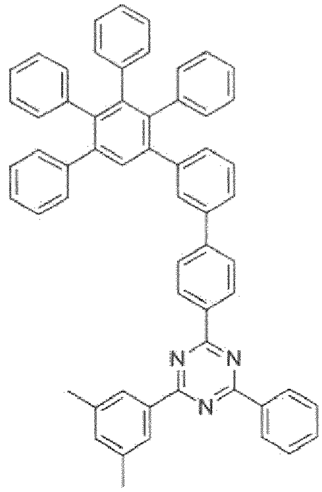

E-2

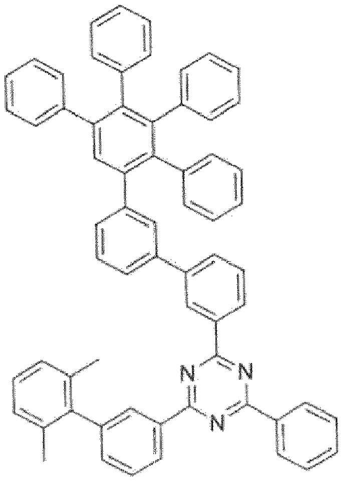

E-3

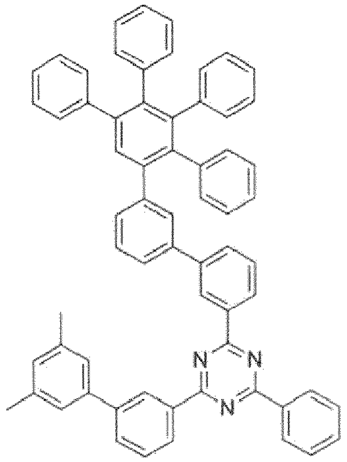

E-4

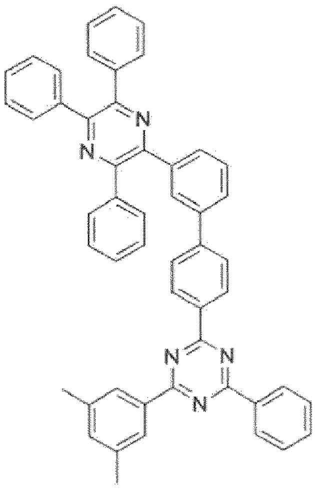

E-5

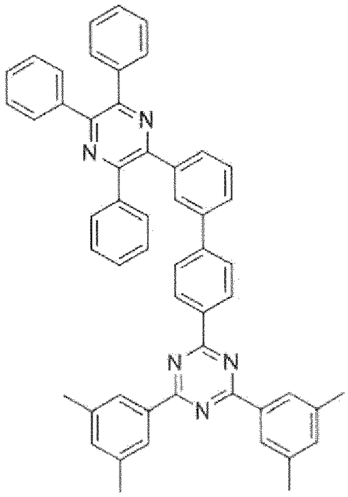

E-6

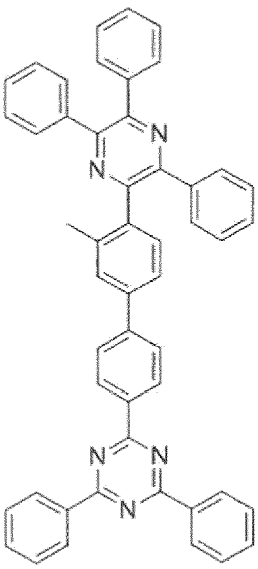

E-7

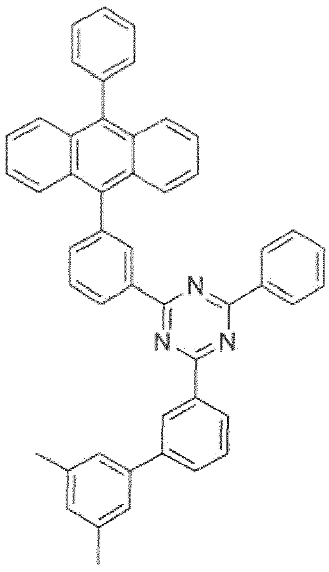

E-8

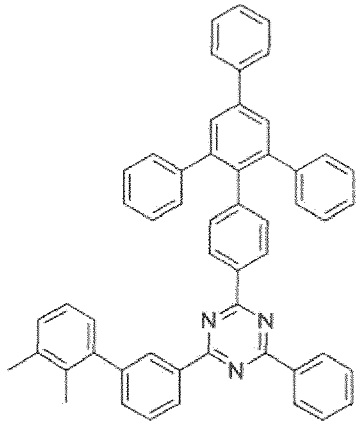

E-9

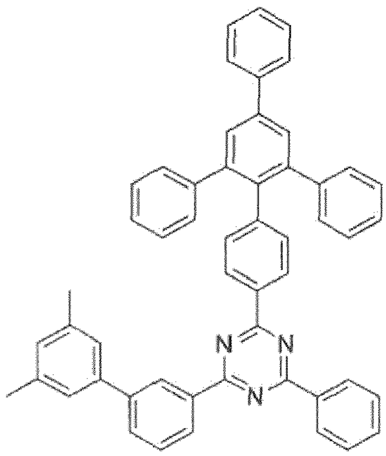

E-10.

Comparative compound CE-1

2,4-diphenyl-6-(4'-(3)5,6-triphenylpyrazin"2-yl)-[1,1'-biphenyl]-4-yl)-1,3,5-triazine CAS 2397584-94-8

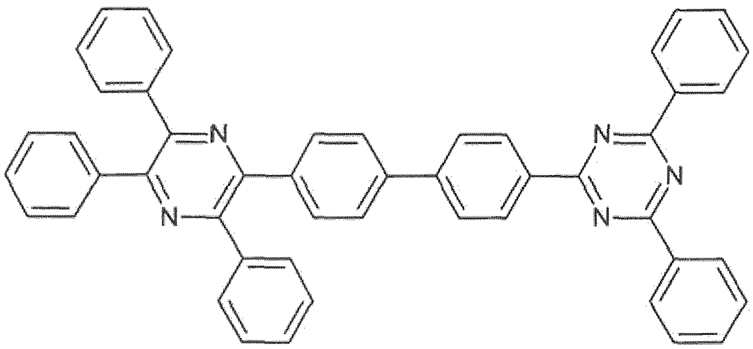

CE-1.

Comparative compound CE-2

2-{[1,1'-biphenyl]-3-yl)-4-phenyl-6-(3-(10-phenylanthracen-9-yl)phenyl)-1,3,5-triazine CAS 2437303-42-7

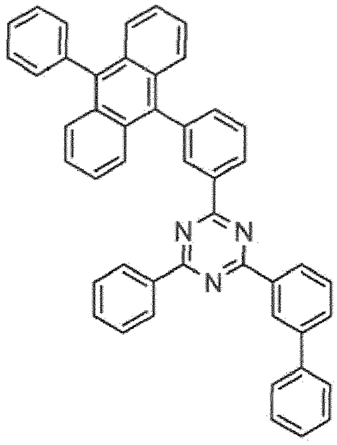

Comparative compound CE-3

2-([1,1'-biphenyl]-3-yl)-4-phenyl-6-(4',5',6'-triphenyl-[1,1':2',1":3",1'''-quaterphenyl]-3'''-yl)-1,3,5-triazine

CAS 2032364-68-2

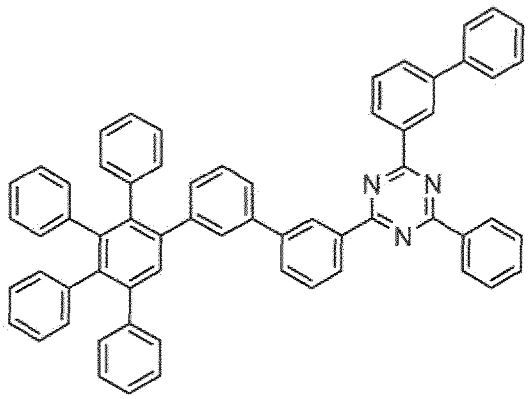

Table 2: Further compounds used:

| | IUPAC name | Reference |
|---|---|---|
| HT-1 | N-([1,1'-biphenyl]-4-yl)-9,9-dimethyl-N-(4-(9-phenyl-9H-carbazol-3-yl)phenyl)-9H-fluoren-2-amine [CAS 1242056-42-3] | US2016322581 |
| HT-2 | N-([1,1'-biphenyl]-4-yl)-9,9-diphenyl-N-(4-(triphenylsilyl)phenyl)-9H-fluoren-2-amine [CAS 1613079-70-1] | WO2014088047 |
| 0-1 | 4,4',4"-((1E,1'E,1"E)-cyclopropane-1,2,3-triylidenetris(cyanomethanylylidene))tris(2,3,5,6-tetrafluorobenzonitrile) [CAS 1224447-88-4] | US2008265216 |
| HOST-1 | Ho9 (Fluorescent-blue host material) | Commercially available from Sun Fine Chemicals, Inc, S. Korea |

(continued)

| | IUPAC name | Reference |
|---|---|---|
| EMIT-TER-1 | BD200 (Fluorescent-blue emitter material) | Commercially available from Sun Fine Chemicals, Inc, S. Korea |
| ET-1 | 2-(2',6'-diphenyl-[1,1':4',1"-terphenyl]-4-yl)-4-phenyl-6-(3-(pyridin-4-yl)phenyl)-1,3,5-triazine [CAS 2869796-06-3] | EP3923364 |
| LiQ | 8-Hydroxyquinolinolato-lithium [CAS 850918-68-2] | WO2013079217 |

Table 3: Performance of OLED Devices, comparative example CE-1

| HBL | CIEy | Voltage, rel. [%] | Ceff/CIEy, rel. [%] |
|---|---|---|---|
| (CE-1) | 0.098 | 100 | 100 |
| (E-1) | 0.098 | 84 | 158 |
| (E-2) | 0.100 | 84 | 156 |
| (E-3) | 0.095 | 82 | 161 |
| (E-4) | 0.095 | 85 | 156 |
| (E-5) | 0.096 | 85 | 136 |
| (E-6) | 0.096 | 84 | 152 |
| (E-7) | 0.097 | 91 | 120 |
| (E-8) | 0.098 | 86 | 136 |
| (E-9) | 0.097 | 84 | 160 |
| (E-10) | 0.097 | 85 | 157 |

Table 4. Performance of OLED Devices, comparative example CE-2

| HBL | CIEy | Voltage, rel. [%] | Ceff/CIEy, rel. [%] |
|---|---|---|---|
| (CE-2) | 0.098 | 100 | 100 |
| (E-1) | 0.098 | 99 | 119 |
| (E-2) | 0.100 | 99 | 117 |
| (E-3) | 0.095 | 97 | 121 |
| (E-4) | 0.095 | 100 | 118 |
| (E-6) | 0.096 | 99 | 114 |
| (E-9) | 0.097 | 99 | 121 |
| (E-10) | 0.097 | 100 | 119 |

Table 5. Performance of OLED Devices, comparative example CE-3.

| HBL | CIEy | Voltage, rel. [%] | Ceff/CIEy, rel. [%] |
|---|---|---|---|
| (CE-3) | 0.096 | 100 | 100 |
| (E-1) | 0.098 | 99 | 101 |
| (E-2) | 0.100 | 99 | 100 |
| (E-3) | 0.095 | 97 | 103 |
| (E-9) | 0.097 | 100 | 103 |
| (E-10) | 0.097 | 100 | 101 |

As it can be seen from Tables 3 to 5, organic light emitting devices in accordance with the present invention comprising a compound of Formula (I) in a hole blocking layer thereof and not comprising an electrical dopant have improved efficiency and driving voltage.

The features disclosed in the foregoing description and in the dependent claims may, both separately and in any combination thereof, be material for realizing the aspects of the disclosure made in the independent claims, in diverse forms thereof.

## Claims

**1.** Organic light emitting device comprising an anode, a cathode, an emission layer, a hole blocking layer, and an electron transport layer,
wherein

- the emission layer, the hole blocking layer and the electron transport layer are arranged between the anode and the cathode;
- the hole blocking layer and the electron transport layer are arranged between the emission layer and the cathode;
- the hole blocking layer is arranged between the emission layer and the electron transport layer;
- the hole blocking layer is in direct contact with the electron transport layer;
- the hole blocking layer does not comprise an electrical dopant;
- the hole blocking layer comprises a compound of formula (I)

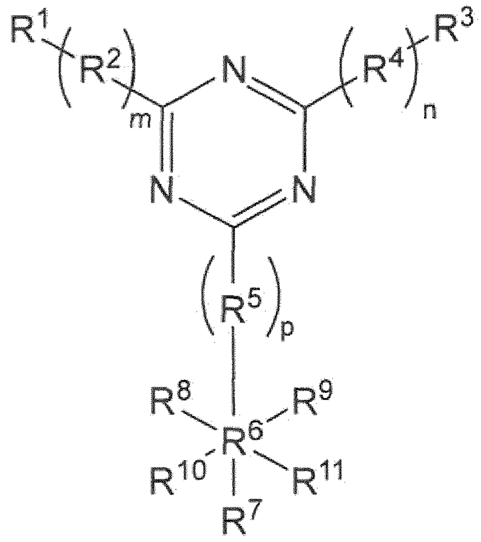

(I)

wherein in formula (I)

- m and n are independently o or 1;
- p is o or 1;
- $m + n + p \geq 1$;
- $R^1$ and $R^3$ are independently substituted or unsubstituted $C_6$ to $C_{18}$ aryl;
- $R^2$ and $R^4$ are independently substituted or unsubstituted $C_6$ to $C_{18}$ arylene;
- $R^5$ is substituted or unsubstituted $C_6$ to $C_{18}$ arylene;
- $R^6$ is selected from the group consisting of phenylene, pyrazinylene and anthracenylene;
- $R^7$ is unsubstituted $C_6$ to $C_{18}$ aryl;
- $R^8$ to $R^{11}$ are independently selected from the group consisting of H and unsubstituted $C_6$ to $C_{18}$ aryl;
- in case that one or more of $R^1$ to $R^5$ is substituted, the one or more substituents are independently $C_1$ to $C_6$ alkyl; and
- at least one of $R^1$ and $R^3$ is substituted with at least one Ct to $C_6$ alkyl substituents; and/or at least one of $R^2$, $R^4$ and $R^5$ is substituted with at least one $C_1$ to $C_6$ alkyl substituents.

**2.** Organic light emitting device according to claim 1, wherein $R^1$ and $R^3$ are independently substituted or unsubstituted phenyl.

**3.** Organic light emitting device according to claim 1 or 2, wherein $R^2$ and $R^4$ are independently substituted or unsubstituted phenylene.

**4.** Organic light emitting device according to any of the preceding claims, wherein $R^5$ is substituted or unsubstituted $C_6$ to $C_{12}$ arylene.

**5.** Organic light emitting device according to any of the preceding claims, wherein $R^6$ is selected from the group consisting of phenylene and pyrazinylene.

**6.** Organic light emitting device according to any of the preceding claims, wherein $R^7$ is unsubstituted phenyl.

**7.** Organic light emitting device according to any of the preceding claims, wherein $R^8$ to $R^{11}$ are independently selected from the group consisting of H and phenyl.

**8.** Organic light emitting device according to any of the preceding claims, wherein at least one of $R^1$ and $R^3$ is substituted with at least two $C_1$ to $C_6$ alkyl substituents; and/or $R^5$ is substituted with at least one $C_1$ to $C_6$ alkyl substituents.

**9.** Organic light emitting device according to any of the preceding claims, wherein in case that one or more of $R^1$ to $R^5$ is substituted, the one or more substituents are each methyl.

**10.** Organic light emitting device according to any of the preceding claims, wherein the compound of formula (I) is selected from E-1 to E-10

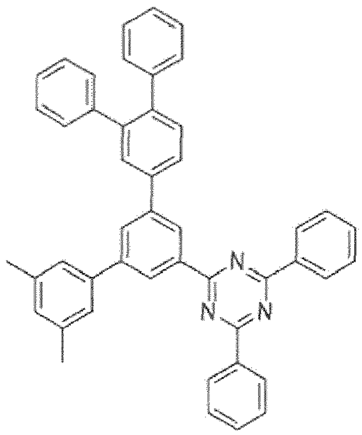

E-1

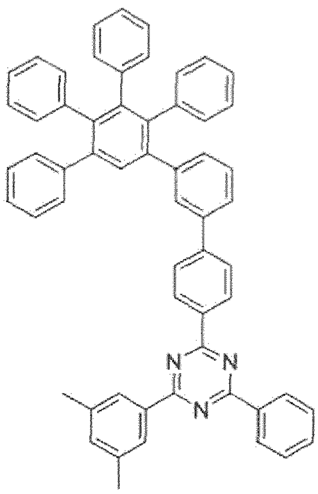

E-2

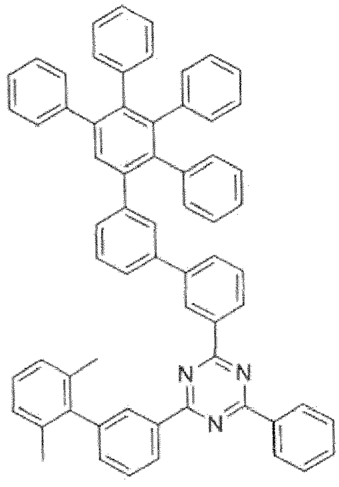
E-3

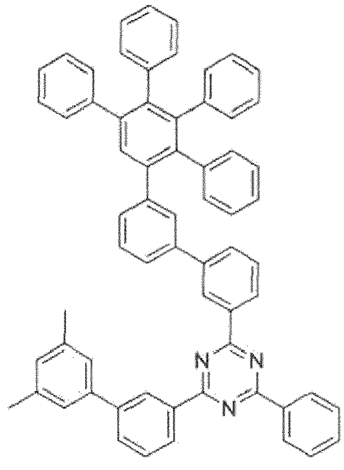
E-4

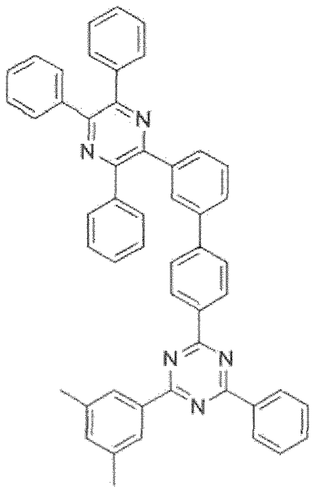
E-5

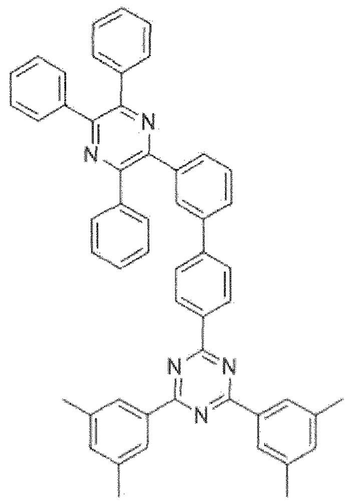
E-6

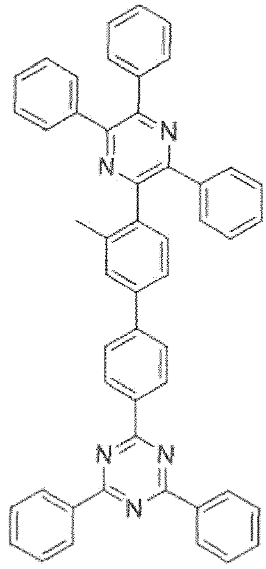
E-7

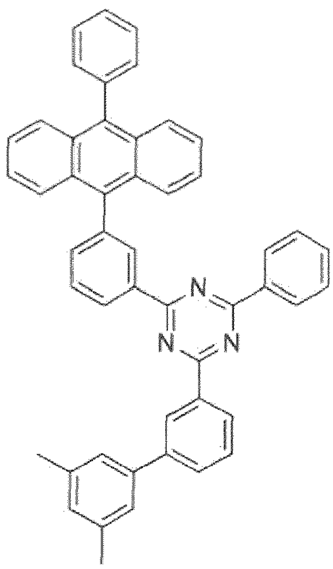
E-8

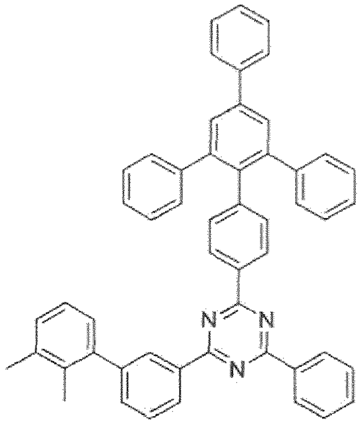
E-9

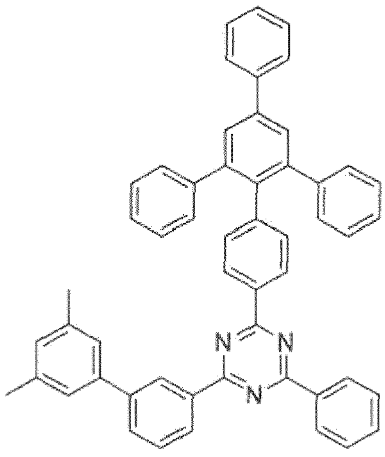
E-10.

**11.** Device comprising the organic light emitting device according to any of the preceding claims, wherein the device is a display device or a lighting device.

**12.** Compound of formula (II)

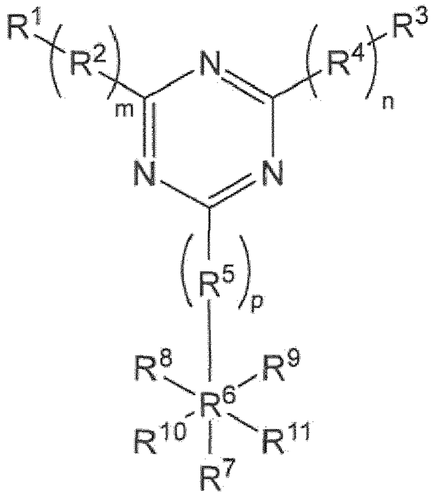
(II)

wherein in formula (II)

- m and n are independently 0 or 1;
- p is o, 1 or 2;
- m + n + p ≥ 1;
- $R^1$ and $R^3$ are independently substituted or unsubstituted phenyl;
- $R^2$ and $R^4$ are independently substituted or unsubstituted phenylene;
- each $R^5$ is independently substituted or unsubstituted phenylene;
- $R^6$ is selected from the group consisting of phenylene, pyrazinylene and anthracenylene;
- $R^7$ is unsubstituted phenyl;
- $R^8$ to $R^{11}$ are independently selected from the group consisting of H and unsubstituted phenyl;
- in case that one or more of $R^1$ to $R^5$ is substituted, the one or more substituents are independently $C_1$ to $C_6$ alkyl; and
- at least one of $R^1$ and $R^3$ is substituted with at least one $C_1$ to $C_6$ alkyl substituents; and/or at least one of $R^2$, $R^4$ and $R^5$ is substituted with at least one $C_1$ to $C_6$ alkyl substituents.

**13.** Compound according to claim 12, wherein at least one of $R^1$ and $R^3$ is substituted with at least two $C_1$ to $C_6$ alkyl substituents; and/or $R^5$ is substituted with at least one $C_1$ to $C_6$ alkyl substituents.

**14.** Compound according to claim 12 or 13, wherein in case that one or more of $R^1$ to $R^5$ is substituted, the one or more

substituents are each methyl.

**15.** Compound according to claim 12 to 14, wherein the compound is selected from E-2 to E-10

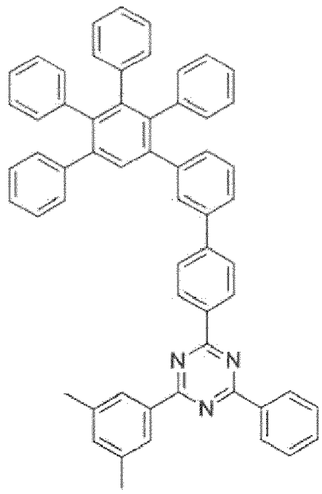

E-2

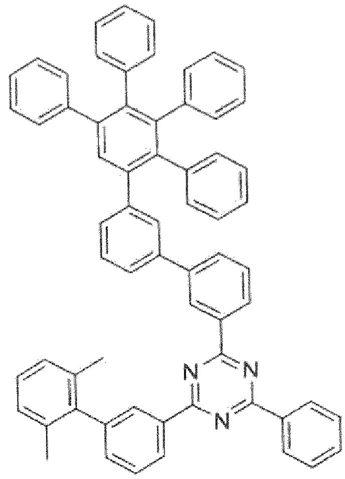

E-3

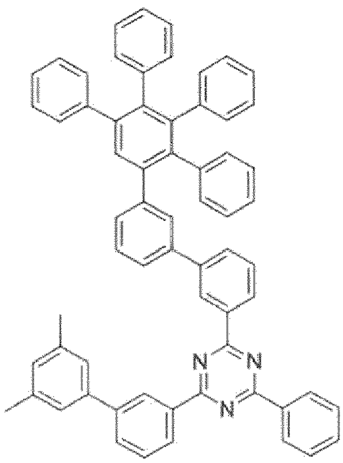

E-4

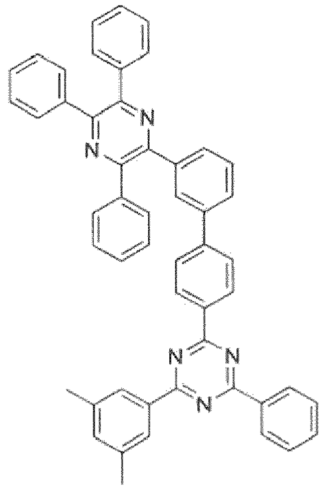

E-5

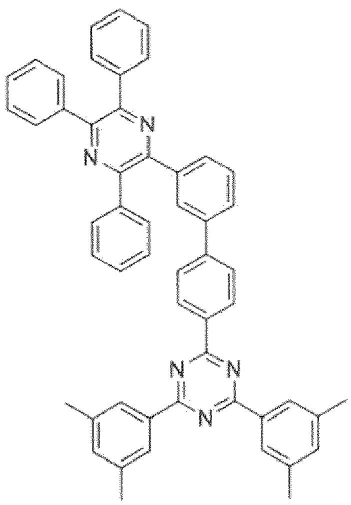

E-6

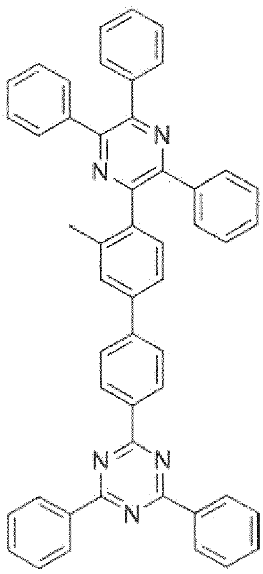

E-7

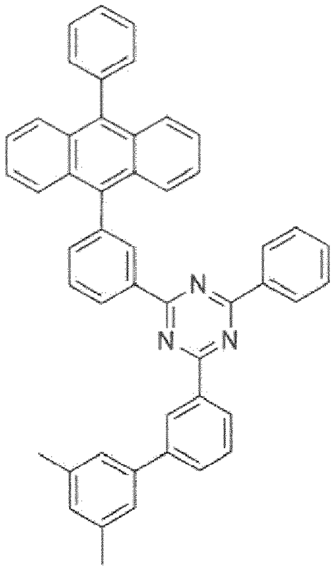
E-8

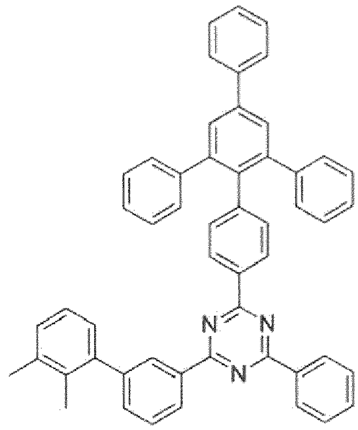
E-9

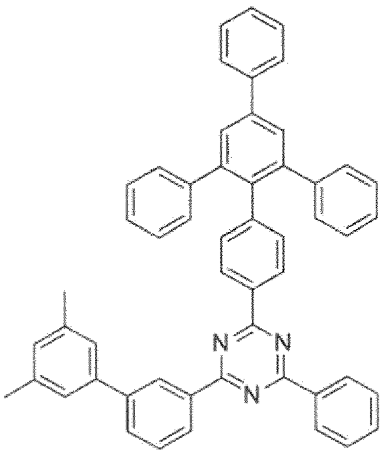
E-10.

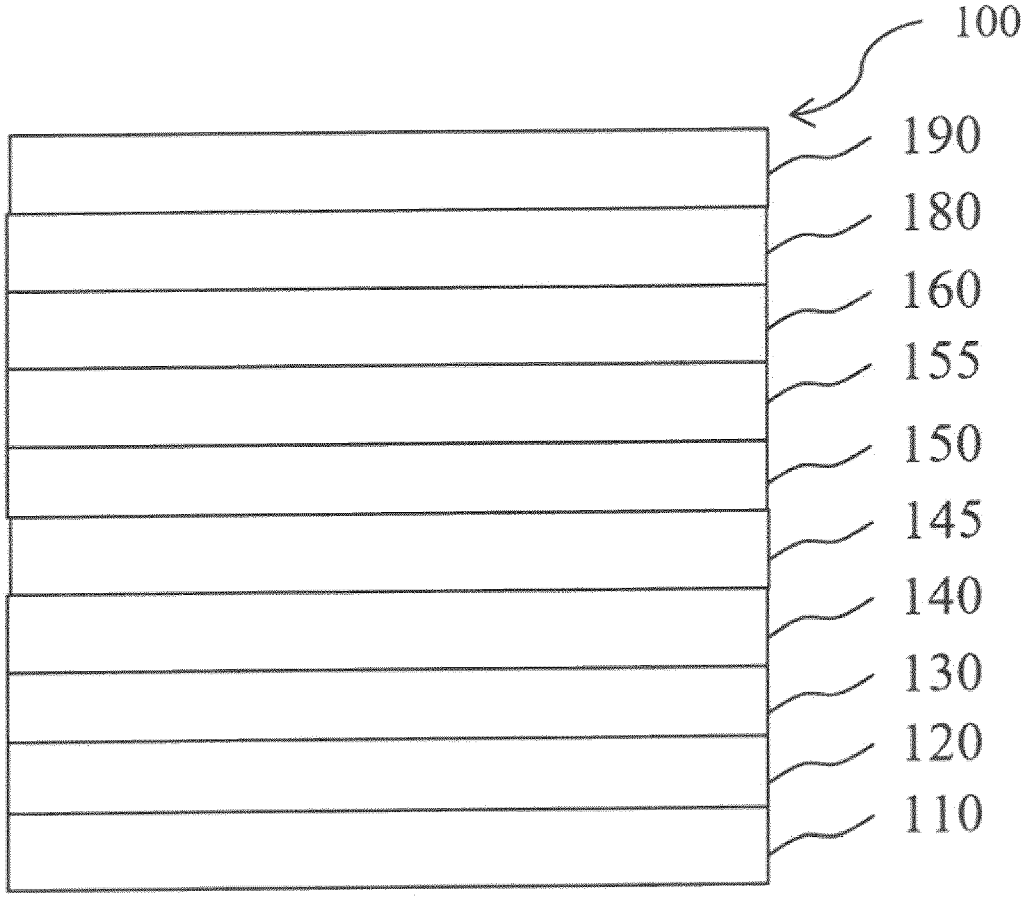


Fig. 1

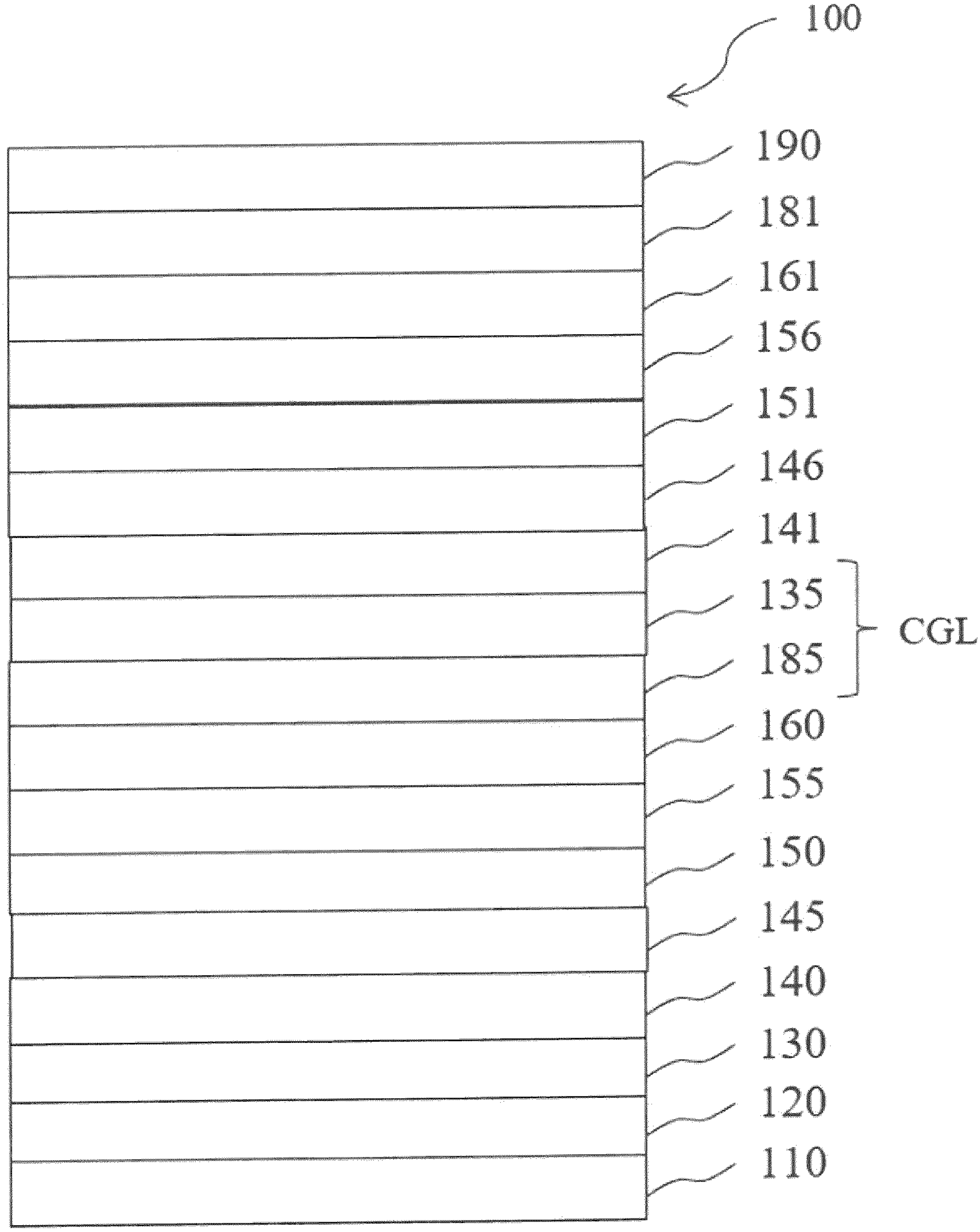
100
190
181
161
156
151
146
141
135
185
CGL
160
155
150
145
140
130
120
110

Fig. 2

Europäisches Patentamt
European Patent Office
Office européen des brevets

# EUROPEAN SEARCH REPORT

Application Number
EP 23 20 0088

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 108 727 358 A (CHANGCHUN HAIPURUNSI TECH CO LTD) 2 November 2018 (2018-11-02) | 1,3,5-9, 11 | INV. H10K85/60 H10K50/18 |
| Y | * paragraphs [0144], [0152], [0024] - [0030], [0007]; compound 62 * ----- | 2,4,10 | |
| X | EP 4 199 133 A1 (NOVALED GMBH [DE]) 21 June 2023 (2023-06-21) | 12-15 | |
| Y | * page 15, paragraph 72; compound G8 * ----- | 2,4,10 | |

TECHNICAL FIELDS SEARCHED (IPC)

H10K

The present search report has been drawn up for all claims

1

| Place of search | Date of completion of the search | Examiner |
|---|---|---|
| Munich | 22 February 2024 | Beierlein, Udo |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 23 20 0088

This annex lists the patent family members relating to the patent documents cited in the above-mentioned European search report. The members are as contained in the European Patent Office EDP file on
The European Patent Office is in no way liable for these particulars which are merely given for the purpose of information.

22-02-2024

| Patent document cited in search report | | Publication date | Patent family member(s) | | Publication date |
|---|---|---|---|---|---|
| CN 108727358 | A | 02-11-2018 | NONE | | |
| EP 4199133 | A1 | 21-06-2023 | EP 4199133 | A1 | 21-06-2023 |
| | | | WO 2023117255 | A1 | 29-06-2023 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2005086251 A
- EP 1837926 B1
- WO 2007107306 A
- WO 2007107356 A
- EP 2722908 A1
- EP 1970371 A1
- WO 2013079217 A1
- US 2016322581 A
- WO 2014088047 A
- US 2008265216 A
- EP 3923364 A
- WO 2013079217 A


### Non-patent literature cited in the description


- **YASUHIKO SHIROTA ; HIROSHI KAGEYAMA**. *Chem. Rev.*, 2007, vol. 107, 953-1010
- *CHEMICAL ABSTRACTS*, 1073062-42-6
- *CHEMICAL ABSTRACTS*, 2144472-52-4
- *CHEMICAL ABSTRACTS*, 14221-01-3
- *CHEMICAL ABSTRACTS*, 584-08-7
- *CHEMICAL ABSTRACTS*, 172975-69-8
- *CHEMICAL ABSTRACTS*, 1798781-99-3
- *CHEMICAL ABSTRACTS*, 7778-53-2
- *CHEMICAL ABSTRACTS*, 30894-93-0
- *CHEMICAL ABSTRACTS*, 872118-08-6
- *CHEMICAL ABSTRACTS*, 2125473-29-0
- *CHEMICAL ABSTRACTS*, 2032365-26-5
- *CHEMICAL ABSTRACTS*, 72287-26-4
- *CHEMICAL ABSTRACTS*, 100379-00-8
- *CHEMICAL ABSTRACTS*, 2437303-47-2
- *CHEMICAL ABSTRACTS*, 51364-51-3
- *CHEMICAL ABSTRACTS*, 564483-18-7
- *CHEMICAL ABSTRACTS*, 1310-58-3
- *CHEMICAL ABSTRACTS*, 1219956-23-6
- *CHEMICAL ABSTRACTS*, 202865-85-8
- *CHEMICAL ABSTRACTS*, 73183-34-3
- *CHEMICAL ABSTRACTS*, 127-08-2
- *CHEMICAL ABSTRACTS*, 243472-78-8
- *CHEMICAL ABSTRACTS*, 183158-34-1
- *CHEMICAL ABSTRACTS*, 2396743-64-7
- *CHEMICAL ABSTRACTS*, 2830402-45-2
- *CHEMICAL ABSTRACTS*, 2576432-81-8
- *CHEMICAL ABSTRACTS*, 1242056-42-3
- *CHEMICAL ABSTRACTS*, 1613079-70-1
- *CHEMICAL ABSTRACTS*, 1224447-88-4
- *CHEMICAL ABSTRACTS*, 2869796-06-3